(19) Europäisches Patentamt
European Patent Office
Office européen des brevets

(11) **EP 1 741 802 B1**

(12) **EUROPEAN PATENT SPECIFICATION**

(45) Date of publication and mention of the grant of the patent:
**21.08.2013 Bulletin 2013/34**

(21) Application number: **05727877.2**

(22) Date of filing: **29.03.2005**

(51) Int Cl.:
*C23C 14/24* (2006.01)   *C23C 14/12* (2006.01)
*C23C 16/448* (2006.01)   *H05B 33/10* (2006.01)
*H05B 33/28* (2006.01)

(86) International application number:
**PCT/JP2005/005928**

(87) International publication number:
**WO 2005/093120 (06.10.2005 Gazette 2005/40)**

(54) **FILM-FORMING APPARATUS AND FILM-FORMING METHOD**

FILMBILDUNGSVORRICHTUNG UND FILMBILDUNGSVERFAHREN

APPAREIL DE FORMATION DE FILM ET PROCEDE DE FORMATION DE FILM

(84) Designated Contracting States:
**DE FR GB IT**

(30) Priority: **29.03.2004   JP 2004097112**

(43) Date of publication of application:
**10.01.2007   Bulletin 2007/02**

(73) Proprietors:
• **Ohmi, Tadahiro**
  **Sendai-shi,**
  **Miyagi 980-0813 (JP)**
• **TOKYO ELECTRON LIMITED**
  **Minato-ku**
  **Tokyo 107-8481 (JP)**

(72) Inventors:
• **OHMI, Tadahiro**
  **Sendai-shi,**
  **Miyagi 9800813 (JP)**
• **MATSUOKA, Takaaki,**
  **TOKYO ELECTRON LIMETED**
  **Tokyo 1078481 (JP)**

(74) Representative: **Glawe, Delfs, Moll**
**Patent- und Rechtsanwälte**
**Postfach 26 01 62**
**80058 München (DE)**

(56) References cited:
WO-A-03/020999   WO-A-03/080893
JP-A- 7 231 936   JP-A- 9 279 346
JP-A- 10 158 820   JP-A- 2000 104 172
JP-A- 2000 160 328   JP-A- 2002 194 548
JP-A- 2003 068 713   JP-A- 2003 301 255
JP-A- 2003 313 654   JP-A- 2004 010 989
JP-A- 2004 010 990   JP-A- 2004 022 674
JP-A- 2004 079 904   JP-A- 2005 058 978

• BALDO M A ET AL: "LOW PRESSURE ORGANIC VAPOR PHASE DEPOSITION OF SMALL MOLECULAR WEIGHT ORGANIC DEVICE STRUCTURES" MATERIALS RESEARCH SOCIETY SYMPOSIUM PROCEEDINGS, MATERIALS RESEARCH SOCIETY, PITTSBURG, PA, vol. 488, 1 December 1997 (1997-12-01), pages 587-592, XP001030436 ISSN: 0272-9172

EP 1 741 802 B1

Printed by Jouve, 75001 PARIS (FR)

**Description**

Technical Field

This invention relates to a film-forming apparatus and a film-forming method for forming a film layer of a predetermined material and, in particular, relates to a film-forming apparatus and a film-forming method for forming a film layer of a predetermined material by evaporating a raw material of the predetermined material.

Background Art

Methods for forming a film layer of a predetermined material by evaporating a raw material of the predetermined material are widely used in the manufacture of such electronic devices as semiconductor devices, flat panel display devices and others. As one example of such electronic devices, description will be given hereinbelow of an organic EL display device. The organic EL display device with sufficiently high brightness and a lifetime of several tens of thousands of hours or more uses an organic EL element that is a self-luminous element and thus can be formed thin with less peripheral components such as a backlight. Therefore, the organic EL display device is ideal as a flat panel display device. The organic EL element forming such an organic EL display device is required, in terms of characteristics as the display device, such that, while being a large screen, the element lifetime is long, there are no variations in luminous brightness on the screen and in element lifetime, there are no defects typified by dark spots, and so on. Film formation of an organic EL layer is quite important for satisfying those requirements.

As a film-forming apparatus for uniformly forming a film of an organic EL layer on a large substrate, use is comprised of an apparatus described in Patent Document 1 or the like. The film-forming apparatus of Patent Document 1 is intended to ensure uniformity of the film thickness on a large substrate by optimally arranging in a tree fashion the piping structure inside an injector located in the apparatus.

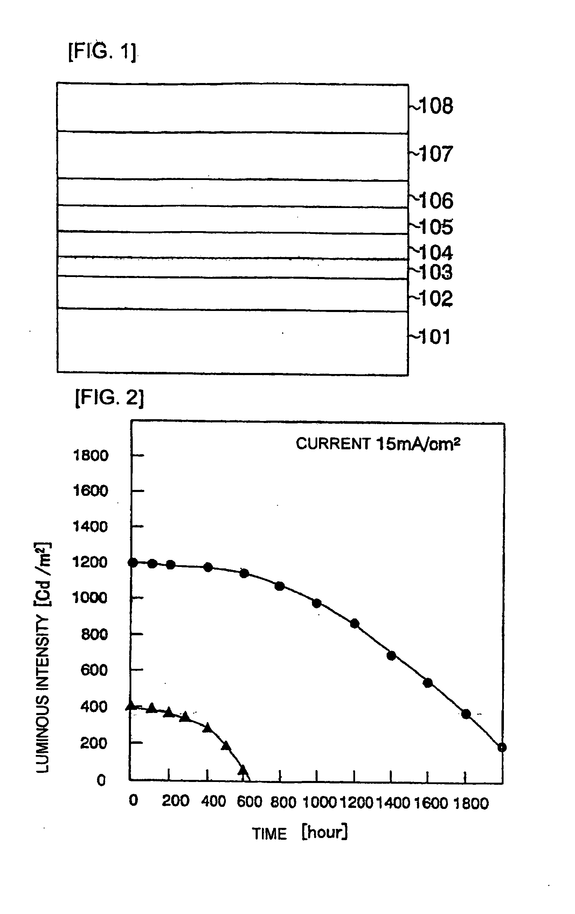

An organic EL layer currently is formed by a vacuum deposition apparatus at $10^{-6}$ Torr to $10^{-7}$ Torr or less. According to an experiment by the inventors, it has been clarified that, in a current organic EL vacuum deposition apparatus, an organic EL layer is subjected to a large amount of organic contamination in an organic EL layer forming process, so that the brightness and lifetime of an organic EL light emitting diode (OLED) are largely reduced. Fig. 1 shows a sectional structure of a green light emitting OLED used in the experiment. A glass substrate 101 has a thickness of 0.3 to 1.0mm, an ITO transparent electrode 102 (work function -4.80eV) has a thickness of 100 to 150mm, an ITO layer 103 has a thickness of 5 to 10mm and a work function controlled to approximately -5.2eV by adding V (vanadium) to approximately several percents, a hole transport layer (NPD) 104 has a thickness of approximately 40nm, a light emitting layer (Alq3) 105 has a thickness of approximately 40nm, an electron injection cathode electrode (MgAg) 106 (work function -3.7eV) likewise has a thickness of approximately 40nm, a metal electrode (Ag) 107 has a thickness of approximately 100nm, and a $SiO_2$ protective film 108 has a thickness of 3 to 5$\mu$m and is adapted to prevent invasion of moisture and so on from the atmosphere. Light is extracted on the glass substrate 101 side. The emission wavelength is approximately 520nm. The ITO transparent electrodes 102 and 103 were sputter-deposited at a temperature of approximately 250°C and then annealed in a $N_2$ gas atmosphere at 300°C. The NPD 104 and Alq3 105 of organic EL films were formed by deposition in a vacuum of approximately 1 x $10^{-7}$ Torr.

A graph of black circles in Fig. 2 shows results of forming films of the NPD layer, the Alq3 layer, and the MgAg electrode layer immediately after transfer of the glass substrate in a continuous vacuum deposition apparatus of a shape provided with a load lock chamber (assuming that the load lock chamber is also set in a vacuum of approximately 1 x $10^{-7}$ Torr). A graph of black triangles in Fig. 2 shows results of leaving the substrate standing in an atmosphere of approximately 1 x $10^{-7}$ Torr for 30 minutes when film formation of the respective layers. The current value was 15mA/cm². The brightness of the sample exposed to the atmosphere of approximately 1 x $10^{-7}$ Torr, for 30 minutes at the time of the film formation of the respective layers was changed to approximately 1/3 and the lifetime in which the brightness was degraded to half was reduced to 1/3 or less.

As a result of repeating assiduous studies about the foregoing lifetime degradation, the inventors of this invention have found that since, in the vacuum state, the partial pressure of organic compound components serving as a source of contamination increases and simultaneously the mean free path of organic compound molecules increases overwhelmingly, organic compound contamination on the substrate surface becomes quite large to thereby reduce the lifetime of the organic EL element.

Further, it has been ascertained that uniformity in film quality and film thickness at the time of the film formation of the organic EL element is quite important for reducing variations in luminous brightness on the screen and in element lifetime. As a film-forming apparatus for uniformly depositing an organic EL thin film, the apparatus described in Patent Document 1 is cited as an example. However, although the film thickness of an organic EL element formed in the apparatus of such a structure is uniform, dark spots or variation in element lifetime occurs.

Further, according to the injector described in Patent Document 1, there arises a problem that since there is no disclosure about the material and temperature of the injector, the organic EL material is deposited inside the injector and decomposed inside the injector depending on the conditions, thereby causing deposition of the decomposition product on the substrate, so that the organic EL element does not function.

Patent Document 1: Japanese Unexamined Patent Application Publication JP-2004-79904-A2

JP 2005-58978 A (and corresponding document US 2006/0278162 A1) discloses a film-forming apparatus usable for manufacture of an organic EL element and comprising a crucible formed from a material having low catalytic activity such as aluminium oxide, aluminium nitride, yttrium oxide and magnesium oxide.

A vacuum deposition apparatus containing a graphite boat for evaporating organic material is disclosed in JP 11-189862 A.

Disclosure of the Invention

Problem to be Solved by the Invention

The conventional film-forming method has a problem that since, basically, the raw material is evaporated from an evaporation dish and adhered to the substrate without directionality (i.e. with non-directionality), the film formation takes time and further it is difficult to form a uniform film. This problem is more serious for film formation on a substrate with an increased area, which is one of the industrial features in recent years. For example, approximately 4 minutes are required for forming a single-color organic EL layer on a glass substrate having a size of 400mm x 500mm, because, since it is composed of a hole injection layer, a hole transport layer, a light emitting layer, an electron injection layer, and so on, it is necessary to carry out film formation of as many as several organic compound layers. Further, as long as approximately 20 minutes are required for completing formation of a three-color organic EL layer including times for transfer, mask changes, and so on, thereby an increase in cost has been caused.

Further, the conventional film-forming method has a problem that since the evaporated raw material is dispersed without directionality, it is also adhered to portions other than the substrate and hence there is much waste. There is also a problem that since the evaporation continues for some time even after heating of the evaporation dish is stopped, a waste of the raw material occurs during non-film formation. For example, since the organic EL film-forming raw material is expensive, these problems are even more serious.

Therefore, an object of this invention is to provide a film-forming apparatus and a film-forming method that can increase the film-forming rate and enable uniform film formation by directing an evaporated raw material toward a substrate.

Another object of this invention is to provide a film-forming apparatus and a film-forming method that are highly economical with a waste of raw material eliminated.

Another object of this invention is to provide a film-forming apparatus and a film-forming method that can carry out film formation on a large-area substrate at a high rate and highly economically.

Still another object of this invention is to provide a film-forming apparatus and a film-forming method with suppressed organic compound contamination.

Means for Solving the Problem

According to this invention, there is obtained a film-forming apparatus according to claim 1 and methods according to claims 19, 36 and 37.

Effect of the Invention

According to this invention, since an evaporated film-forming material reaches the surface of a substrate by the flow of a transport gas, the film-forming conditions can be controlled by the flow of the gas and hence a uniform thin film can be deposited on the large-area substrate. That is, by directing the evaporated raw material toward the substrate, it is possible to increase the film-forming rate and achieve uniform ilm formation. For example, approximately one to two minutes are enough for forming a three-color organic EL layer on a glass substrate having a size of 400mm x 500mm and hence the film-forming time can be shorted to 1/10 or less as compared with conventional. By directing the evaporated raw material toward the substrate, by raising the temperature of a portion other than the substrate to an evaporation temperature or more to prevent unnecessary adhesion of the evaporated raw material, or by using a heavy gas such as xenon for transport so as to fix the flow of the raw material in a constant direction, the expensive raw material can be selectively adhered only on the substrate, thereby enabling highly economical film formation with a waste of the raw material eliminated. Further, since use is comprised of the method that transfers the evaporated film-forming material on the flow of the transport gas, it is possible to stop ejection of the raw material by stopping the flow of the gas during non-film formation and hence it is possible to prevent generation of waste of the raw material.

The film-forming apparatus of this invention thoroughly eliminates generation of the organic compound contamination substance/material decomposition dissociation substance that adversely affects the properties of the film-forming material, and thus can deposit a high-quality thin film. By using the film-forming apparatus of this invention for forming an organic EL element, it is possible to obtain a high-quality organic EL display device with high brightness and long lifetime.

Brief Description of the Drawings

[Fig. 1] Fig. 1 is a diagram showing a sectional structure of a green light emitting OLED.

[Fig. 2] Fig. 2 is a graph showing the time dependence of luminous intensities of OLEDs.

[Fig. 3] Fig. 3 is a graph showing the mean free paths of neutral gas atoms.

[Fig. 4] Fig. 4 is a graph showing the time dependence of organic compound amounts adsorbed on the surfaces of substrates left standing in a depressurizing apparatus and a clean room.

[Fig. 5] Fig. 5 is a graph showing the storage pressure dependence of organic compound adhered to the surfaces of wafers.

[Fig. 6] Fig. 6 is a graph showing the chamber-fed $N_2$ gas flow rate dependence of adsorption organic amounts on the surfaces of substrates at a storage pressure of 3 Torr.

[Fig. 7] Fig. 7 is a graph showing the time dependence of adsorption organic compound amount on the surface of a substrate in a vacuum state of 7.5 x $10^{-8}$ Torr.

[Fig. 8] Fig. 8 is a graph showing the temperature dependence of ion currents of mass numbers 28, 43, and 57 measured by a quadrupole mass spectrometer in a chamber at a pressure of 7.5 x $10^{-8}$ Torr where a $SiO_2$ coated silicon substrate adhered with eicosane ($C_{20}H_{42}$) is located.

[Fig. 9] Fig. 9 is a graph showing the pressure dependence of ion currents of mass numbers 28, 43, and 57 by the use of a quadrupole mass spectrometer when the pressure in a chamber is changed by a $N_2$ gas while maintaining the temperature constant.

[Fig. 10] Fig. 10 is a graph showing the temperature dependence of ion currents, by the use of a quadrupole mass spectrometer, of mass numbers 43 and 57 being dissociated molecules of eicosane ($C_{20}H_{42}$) in an atmospheric vacuum atmosphere of 7.5 x $10^{-8}$ Torr.

[Fig. 11] Fig. 11 is a graph showing the time dependence of substrate surface adsorption amounts of $C_{20}H_{42}$ molecules when the pressure in a chamber is changed to 90 Torr, 10 Torr, and 3 Torr.

[Fig. 12A] Fig. 12A is a graph showing characteristics of $C_{20}H_{42}$ molecules and is the graph showing surface equilibrium adsorption amounts of substrate surface adsorption.

[Fig. 12B] Fig. 12B is a graph showing characteristics of $C_{20}H_{42}$ molecules and is the graph showing the pressure dependence of adsorption time constant.

[Fig. 13] Fig. 13 is a graph showing the pressure dependence of substrate surface adsorption amounts of $C_{20}H_{42}$ molecules when the exposure time of the surfaces of substrates is changed to seven kinds from 1 minute to 400 minutes.

[Fig. 14A] Fig. 14A is a graph showing the molecular weight dependence of adsorption amount in the case of straight-chain hydrocarbon adsorbed on the substrate surface at room temperature under the atmospheric pressure.

[Fig. 14B] Fig. 14B is a graph showing the molecular weight dependence of adsorption amount in the case of phthalate ester adsorbed on the substrate surface at room temperature under the atmospheric pressure.

[Fig. 14C] Fig. 14C is a graph showing the molecular weight dependence of adsorption amount in the case of cyclic siloxane adsorbed on the substrate surface at room temperature under the atmospheric pressure.

[Fig. 15] Fig. 15 is a schematic diagram showing the structure of a gas exhaust system of a reduced-pressure deposition apparatus.

[Fig. 16] Fig. 16 is a graph showing the relationship between chamber pressure and gas flow rate given to a chamber.

[Fig. 17A] Fig. 17A is a diagram showing a molecular structure of Alq3.

[Fig. 17B] Fig. 17B is a diagram showing a molecular structure of NPD.

[Fig. 18] Fig. 18 is a diagram showing a schematic structure of an experimentation system for evaluating dissociation of Alq3 molecules.

[Fig. 19] Fig. 19 is a graph showing FT-IR absorption spectra of evaporated Alq3 at (a) and FT-IR absorption spectra of solid Alq3 at (b), respectively.

[Fig. 20] Fig. 20 is a graph showing FT-IR absorption spectra of water molecules ($H_2O$) and a $CO_2$ gas.

[Fig. 21] Fig. 21 is a graph showing IR spectra identification of Alq3.

[Fig. 22] Fig. 22 is a graph showing the temperature dependence of respective Alq3 peaks.

[Fig. 23] Fig. 23 is a graph showing comparison between infrared absorption spectra of NPD in a gas phase at (a) and in a solid phase at (b).

[Fig. 24] Fig. 24 is a graph showing infrared absorption spectra of NPD molecules.

[Fig. 25] Fig. 25 is a graph showing the temperature dependence of respective NPD peaks in the evaporation dish.

[Fig. 26] Fig. 26 is a sectional view showing a schematic structure of an organic film-forming apparatus.

[Fig. 27] Fig. 27 is a graph for explaining Cu elution amounts in various waters.

[Fig. 28] Fig. 28 is a diagram for explaining the structure of a temperature control cooling water circulation system.

[Fig. 29] Fig. 29 is a diagram for explaining the shape of a cooling pipe.

[Fig. 30] Fig. 30 is a diagram for explaining the structure of a temperature control cooling water circulation system.

[Fig. 31] Fig. 31 is a diagram showing a section of an organic compound molecule ejection apparatus portion.

[Fig. 32] Fig. 32 is a diagram showing the structure of a substrate upward type organic film-forming apparatus.

[Fig. 33] Fig. 33 is a diagram showing the structure of a substrate sideward type organic film-forming apparatus.

[Fig. 34] Fig. 34 is a diagram showing the structure of an organic film-forming apparatus having a Xe or Kr gas recovery circulation system.

[Fig. 35] Fig. 35 is a diagram showing the structure of a Kr circulation supply apparatus.

[Fig. 36] Fig. 36 is a diagram showing the structure of a Xe circulation supply apparatus.

[Fig. 37] Fig. 37 is a diagram showing the structure of an Ar/Kr circulation supply apparatus.

[Fig. 38] Fig. 38 is a diagram showing the structure of an Ar/Xe circulation supply apparatus.

[Fig. 39A] Fig. 39A is a sectional view showing the structure of a gas levitation transfer apparatus.

[Fig. 39B] Fig. 39B is a perspective view showing the structure of the gas levitation transfer apparatus.

[Fig. 40] Fig. 40 is an exemplary diagram for schematically explaining a section of a film-forming apparatus.

Best Mode for Carrying Out the Invention

Hereinbelow, description will be given of facts clarified by the inventors of this invention.

(Contamination from the Atmosphere)

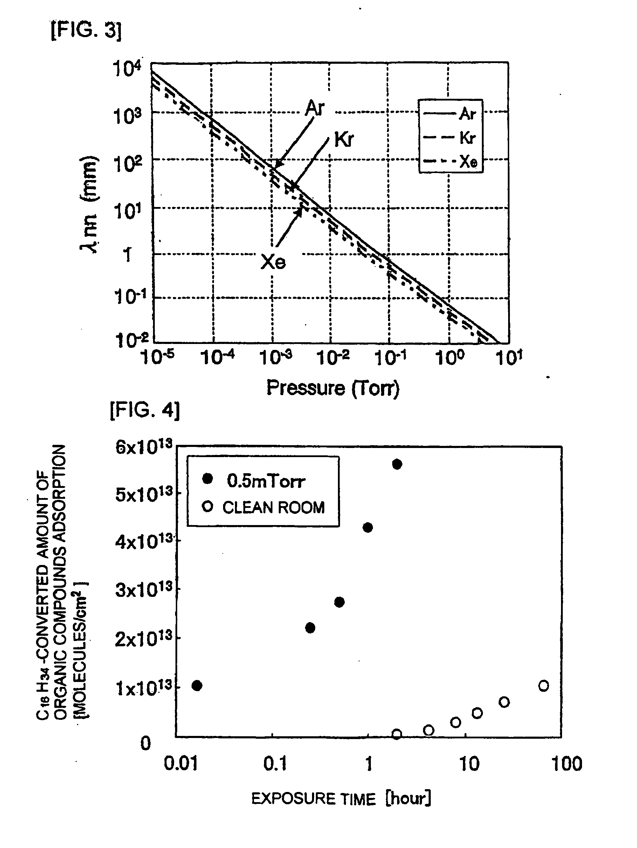

Fig. 3 shows the gas pressure dependence of the mean free paths of Ar (mass number 40), Kr (mass number 80), and Xe (mass number 131) being typical gases. The mean free path increases in inverse proportion to the pressure and decreases when gas atoms/molecules increase in weight or the collision cross section increases. The mean free path normally reaches several hundred meters at $1 \times 10^{-7}$ Torr. It is well known that when the surface of a substrate is exposed to air in a clean room, a large amount of organic compound is adsorbed thereon.

(State of Contamination under Reduced Pressure)

Fig. 4 shows the time dependence of organic compound adsorption on the surfaces of thermal oxide film ($SiO_2$) coated silicon substrates when the substrates were exposed in a clean room at room temperature T and in a substrate transfer chamber is depressurized to 1 mTorr or less. The organic compound adsorbed on the substrate surfaces was measured by a thermal desorption gas chromatograph/mass spectral method. The organic compound adsorption amount is indicated in terms of straight-chain hydrocarbon hexadecane ($C_{16}H_{34}$, $CH_3(CH_2)_{14}CH_3$: molecular weight 226). Fig 4 shows that the adsorption amount of organic compound is much greater under vacuum reduced pressure which has been considered a clean atmosphere. The origins of such organic compound are components adsorbed on the inner surfaces of the chamber from the atmosphere when the inside of the chamber is exposed to the atmosphere, evaporation of grease or the like applied to mechanical sliding portions for substrate transfer or the like, evaporation from plastic O-rings for maintaining the atmospheric vacuum reduced pressure, back diffusion, to the chamber, of evaporated components of grease on the secondary side of a gas exhaust pump coupled for vacuum evacuation, and so on.

(Organic compound Adsorption Mechanism under Reduced Pressure)

Description will be next given of organic compound adsorption behavior onto the surface of a substrate under reduced pressure.

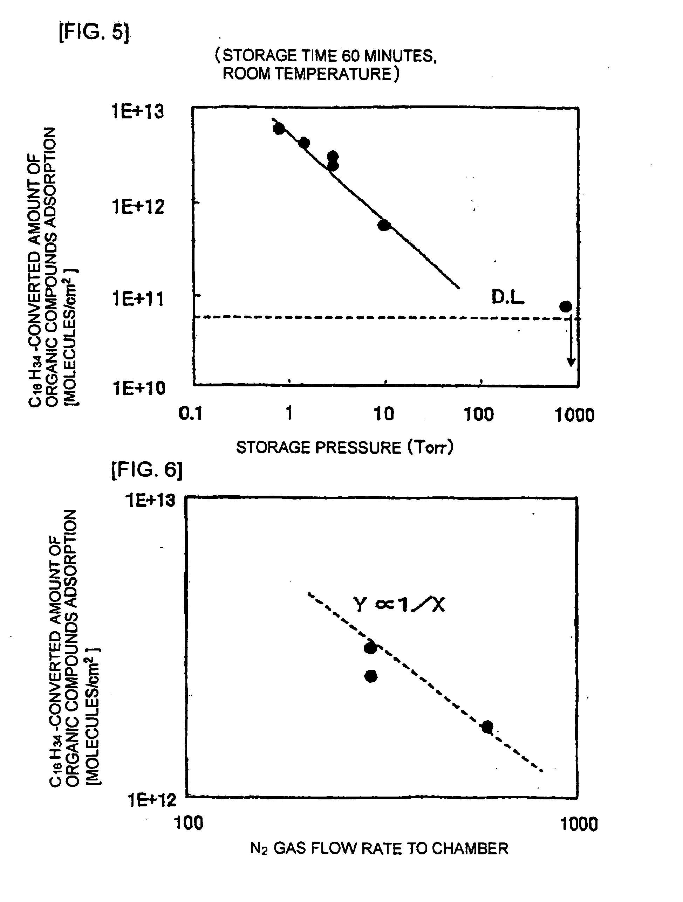

Fig. 5 shows the storage pressure dependence of surface-adsorbed organic compound amounts when thermal oxide film coated silicon substrates treated with a 0.5% HF solution for 5 minutes and rinsed with ultrapure water for 20 minutes were exposed to atmospheres of 0.8 Torr to 10 Torr at room temperature for 60 minutes. The storage pressure was controlled by setting the $N_2$ gas flow rate constant at 300cc/min and changing the pumping speed of an exhaust pump.

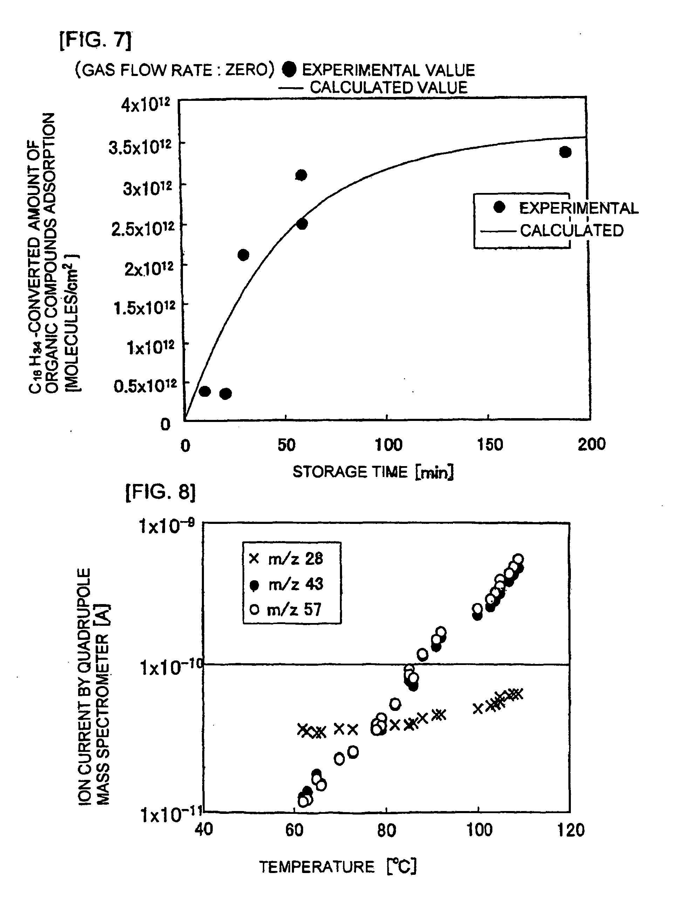

Even in the viscous flow region of 0.8 Torr to 10 Torr, when the pressure decreases so that the partial pressure of organic compound increases and the mean free path increases, the adsorption organic compound amount increases in inverse proportion to the storage pressure. Fig. 6 shows measurement results of adsorption organic compound amounts on the surfaces of substrates when the gas flow rate to a chamber was increased to 500cc/min from 300cc/min while fixing the storage pressure at 3 Torr in the same experiment. The results of Fig. 6 show that the adsorption organic compound amount decreases in inverse proportion to the increase in gas flow rate even under the same storage pressure. That is, by increasing the gas flow rate to reduce the partial pressure of organic compound, the adsorption organic compound amount decreases even when the mean free path of organic compound molecules is the same. It has already been made clear that substrate surface adsorption of organic compound molecules at the atmospheric pressure can be described by the Langmuir monomolecular adsorption model. How will it be under vacuum or reduced pressure ? Fig. 7 shows the time dependence of organic compound amount adsorbed on the surface of a thermal oxide film coated silicon substrate left standing at a vacuum pressure of $7.5 \times 10^{-8}$ Torr (gas flow rate : zero). In Fig. 7, there are shown calculated values of time variation of an adsorption organic compound amount C (molecules/cm$^2$) based on the Langmuir monomolecular adsorption model

$$C(t) = Ce \; (1 \cdot 10^{-t/\tau}) \qquad (1)$$

where Ce represents a surface equilibrium adsorption amount (molecules/cm$^2$) and $\tau$ an adsorption time constant. The results of Fig. 7 show that the adsorption of organic compound onto the substrate surface can be described by the Langmuir monomolecular adsorption model even under vacuum or reduced pressure.

Next, description will be given of the temperature/pressure dependence of organic compound amounts evaporated from organic compound adsorbed on the inner surfaces of a chamber, grease, plastics, and O-rings. Fig. 8 shows ion currents of mass numbers 28, 43, and 57 measured by a quadrupole mass spectrometer when the temperature is changed in the state where a thermal oxide film coated silicon substrate adhered with eicosane ($C_{20}H_{42}$:$CH_3(CH_2)_{18}CH_3$ : molecular weight 282, vapor pressure at 25°C : $9.1 \times 10^{-5}$mmHg, melting point 36°C, boiling point 237 to 240°C) being straight-chain hydrocarbon is located in a chamber maintained at $7.5 \times 10^{-8}$ Torr. The ion current of mass number 28 represents $N_2$ molecules being the residue of the atmosphere, while the ion currents of mass numbers 43 and 57 represent ion currents of dissociated components of the eicosane ($C_{20}H_{42}$ : molecular weight 282). Although the $N_2$ molecule ion current hardly depends on the temperature, the $C_{20}H_{42}$ ion currents increase exponential-functionally along with the temperature rise.

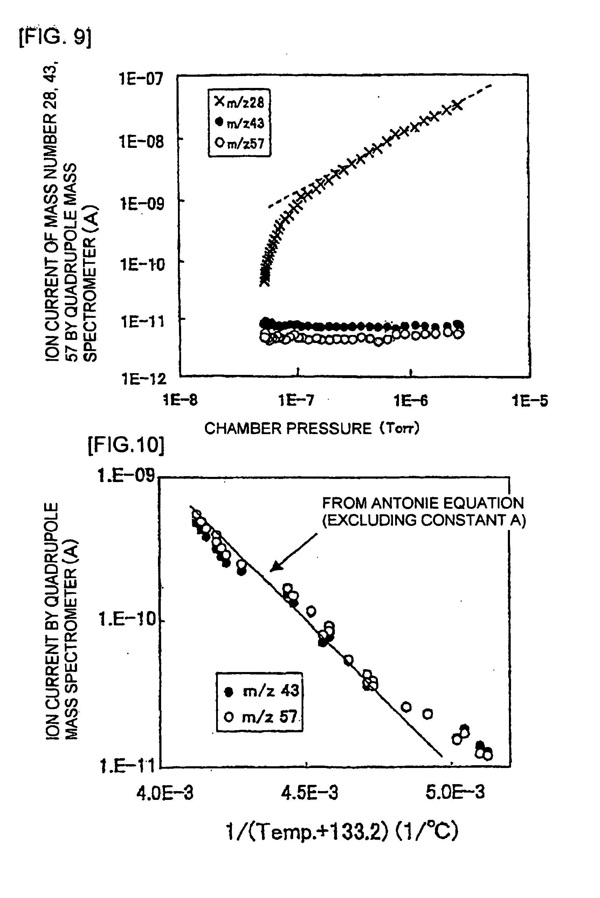

On the other hand, Fig. 9 shows the pressure dependence of ion voltages of mass numbers 28, 43, and 57 likewise by the quadrupole mass spectrometer when the pressure in the chamber is changed from $7.5 \times 10^{-8}$ Torr to $3 \times 10^{-6}$ Torr by a $N_2$ gas while maintaining the temperature constant. Fig. 9 shows that even if the pressure (total pressure) in the chamber is changed by approximately two digits, the pressure of $C_{20}H_{42}$ does not change at all. That is, it has been confirmed that the vapor pressure of organic compound molecules ($C_{20}H_{42}$ in this case) depends only on the temperature and does not depend on the pressure.

A vapor pressure Pv of organic compound molecules to the gas phase is normally described by the Antonie equation. That is,

$$Pv = 10^A \; x \; 10^{-B/(C+T(°C))} \qquad (2)$$

Fig. 10 shows the results of replotting the results of $C_{20}H_{42}$ in Fig. 8 so as to match the Antonie equation. The results of Fig. 10 show that, given that A = 7.0664, B = 1,994.0°C, and C = 133.2°C, the vapor pressure of $C_{20}H_{42}$ can be accurately expressed by the Antonie equation. It has been confirmed that the vapor pressure of organic compound molecules adsorbed on the surfaces or included in the materials hardly depends on the pressure of an atmosphere but depends only on the temperature so as to increase exponential-functionally along with the temperature rise and can be described almost accurately by the Antonie equation. Therefore, it is important for designing/manufacturing a manufacturing apparatus to have a structure where the temperatures of grease-applied portions and resin O-ring portions are maintained as low as possible to thereby suppress the evaporation of organic compound molecules.

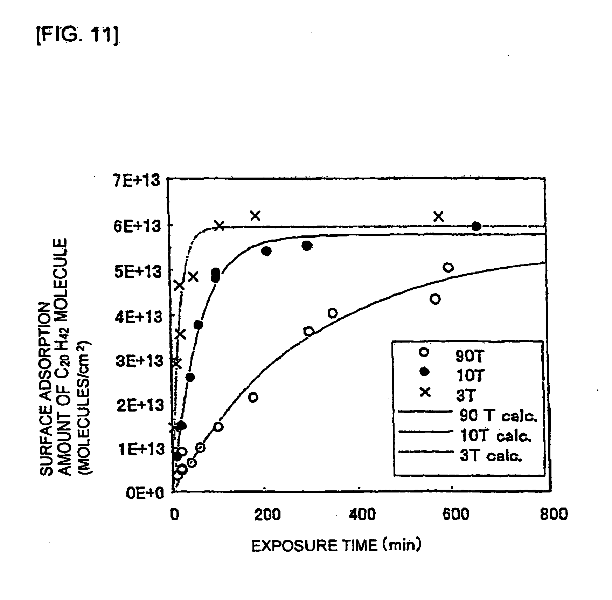

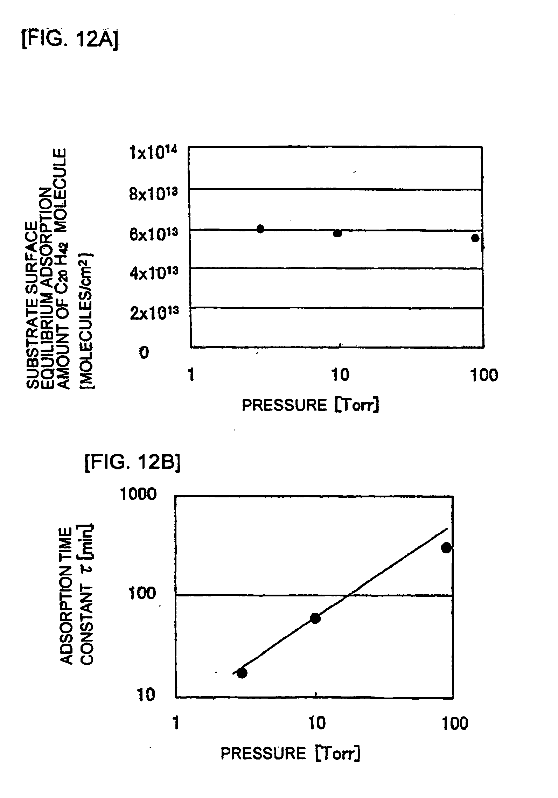

It was possible to clarify the evaporation behavior of eicosane ($C_{20}H_{42}$) as described above. Fig. 11 shows the results of inserting SiO$_2$ coated silicon substrates with clean surfaces in the same chamber and examining the atmospheric pressure dependence of $C_{20}H_{42}$ molecule adsorption onto the clean silicon substrate surfaces. In Fig. 11, there is shown the exposure time dependence of the numbers of $C_{20}H_{42}$ molecules adsorbed on the clean SiO$_2$ coated silicon substrates when the pressure in the chamber is changed to three kinds, i.e. 90 Torr, 10 Torr, and 3 Torr. It is clear from Fig. 11 that the surface equilibrium adsorption amount hardly changes even if the pressure in the chamber changes and that the adsorption time constant decreases along with the pressure drop. Surface equilibrium adsorption amounts Ce (molecules/cm$^2$) and adsorption time constants $\tau$(min) derived from the foregoing Equation (1) of the Langmuir monomolecular adsorption are shown in Table 1 and the pressure dependence thereof is shown in Figs. 12A and 12B. It has been made clear that the adsorption time constant decreases as the pressure decreases so that the partial pressure of $C_{20}H_{42}$

molecules increases and the mean free path increases.

[Table 1]

Table 1 Surface Equilibrium Adsorption Amounts Ce and Adsorption Time Constants $\tau$ at Respective Pressures

| Pressure | Ce (molecules/cm$^2$) | $\tau$(min) |
|---|---|---|
| 90 Torr | 5.54E+13 | 300.0 |
| 10 Torr | 5.76E+13 | 59.5 |
| 3 Torr | 5.94E+13 | 17.3 |

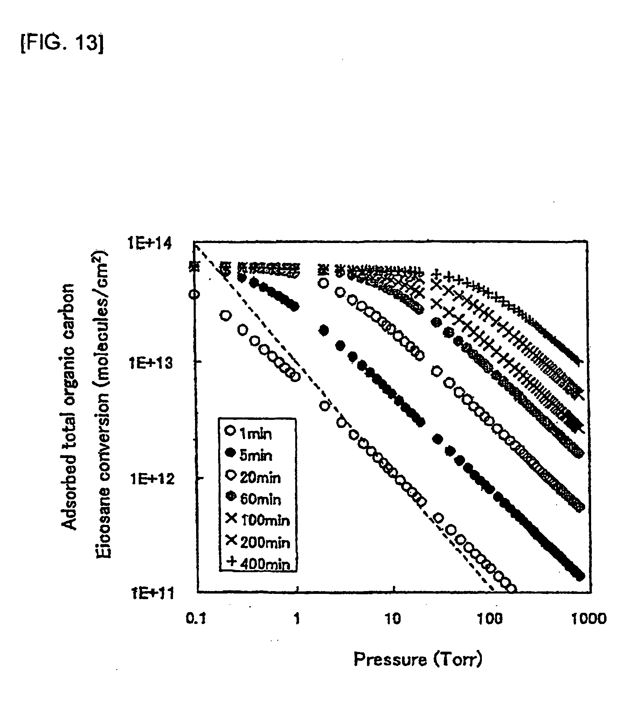

Fig. 13 shows the atmospheric pressure dependence of substrate surface adsorption amounts of $C_{20}H_{42}$ molecules when the exposure time of the surfaces of substrates is changed to seven kinds from 1 minute to 400 minutes.

The technique has become obvious that thoroughly suppresses organic compound molecule adsorption onto the substrate surface for ultrahigh-quality process management.

(1) To suppress as low as thoroughly possible the partial pressure of organic compound molecules in a process chamber and a substrate transfer chamber.
(2) To maintain as high as possible the pressure to a process chamber and a substrate transfer chamber within the range where no inconvenience occurs.
(3) To shorten as much as possible the residence time of a substrate in a process chamber and a substrate transfer chamber in a depressurized state.

Organic compound contamination sources in the depressurizing chamber relating to item (1) are (a) resin O-rings for use in maintaining hermetic sealing, (b) grease for use in lubricating sliding portions (it is a principle to eliminate sliding portions in the chamber as much as possible), (c) back diffusion of oil from the outlet side of a gas exhaust pump, (d) organic compound adsorption onto the inner surfaces of the chamber from the atmosphere when the inside of the chamber is exposed to the atmosphere, and (e) organic compound adsorption onto the front and back surfaces of a substrate from the atmosphere.

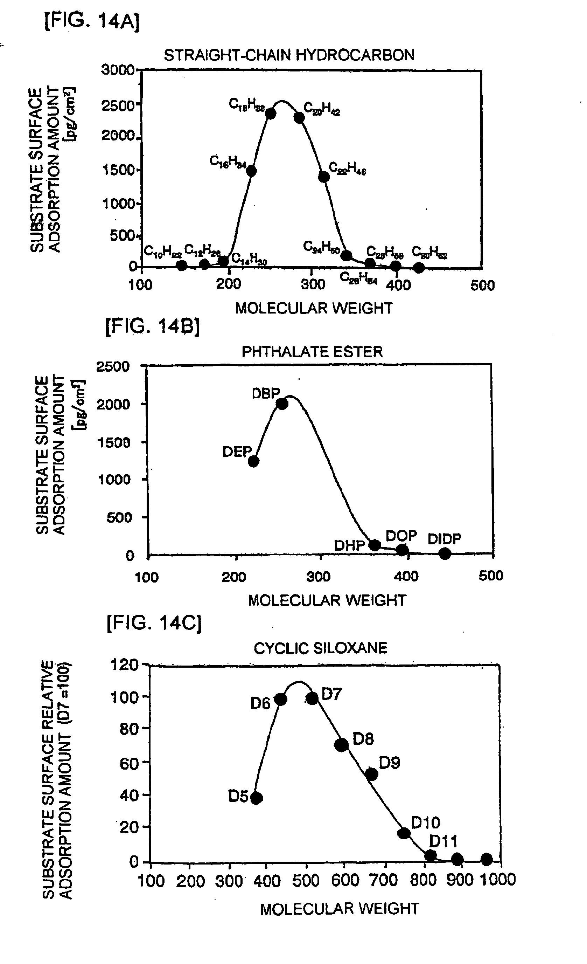

There is no alternative but to use the resin O-ring of item (a) at a portion that is repeatedly opened and closed, like a gate valve provided at a substrate carry-in or carry-out portion. Organic compound released from plastics is in the form of molecules having a relatively small molecular weight. Figs. 14A to 14C show the results of examining adsorption amounts on the surfaces of substrates at room temperature under the atmospheric pressure by changing the molecular weights of straight-chain hydrocarbon ($C_nH_{2n+2}$), phthalate ester, and cyclic siloxane, respectively

An organic compound molecule having a small molecular weight is not adsorbed on the surface of the substrate because its adsorption/desorption activation energy is small. Since the organic compound molecule having a molecular weight greater than a certain value (approximately 400 in the case of straight-chain hydrocarbon or phthalate ester and approximately 900 in the case of cyclic siloxane) is not released into the gas phase because its vapor pressure is small, it is not adsorbed on the substrate. Naturally, as the temperature rises, the critical molecular weight of organic compound released into the gas phase shifts to the greater side more and more. Use should be comprised of an O-ring of a resin that contains no low-molecular-weight organic compound that is released into the gas phase and adsorbed on the substrate surface (e.g. DU351 manufactured by Daikin Industries, Ltd.). With respect also to the grease in item (b), use should be comprised of one that contains no low-molecular-weight organic compound that is released into the gas phase.

It is desirable that there be no mechanical sliding portions and the temperature of an O-ring using grease or a grease-using portion be set as low as possible. When using it at high temperature, since the release critical molecular weight shifts to the higher side, taking it into account, organic compound having a molecular weight of 800 or less is not contained in the case of straight-chain hydrocarbon or phthalate ester, organic compound having a molecular weight of 1500 or less is not contained in the case of cyclic siloxane, and so on.

In order to suppress the back diffusion, into the chamber, of organic compound emitted from grease at a pump gear portion in item (c), it is necessary to feed to a purge port a high purity gas such as Ar or $N_2$ which does not adversely affect a process even if it flows backward into the chamber, so that the pressure of the portion where gears and so on using the grease are present never drops to the molecular flow region but is surely controlled in the viscous flow region.

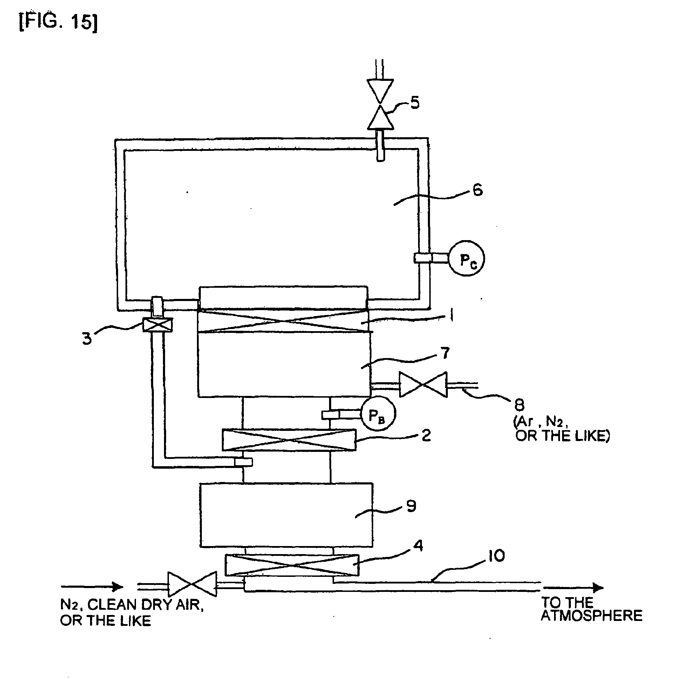

Fig. 15 shows a pump system coupled to a chamber 6 of an organic film-forming apparatus. In Fig. 15, there are included valves 1 to 5, the chamber 6, a turbo-molecular pump 7, a purge port 8, a roughing vacuum pump 9, and an exhaust duct 10.

The high-vacuum evacuation turbo-molecular pump 7 (pumping speed $S_1$ (litter/sec)) is coupled to the chamber 6 through the gate valve 1 (butterfly valve or the like) and is coupled to the roughing vacuum pump 9 (pumping speed

$S_2$ (litter/min)) through the valve 2. An Ar or $N_2$ gas, which does not affect a process even if it flows backward into the chamber 6, is fed to the purge port 8 of the turbo-molecular pump 7. The roughing vacuum pump 9 is directly coupled to the chamber 6 through the valve 3. The roughing vacuum pump 9 is coupled to the exhaust duct 10 through the valve 4 and an exhaust gas is discharged into the atmosphere from the exhaust duct 10. A $N_2$ gas or a clean dry air containing no moisture or organic compound is fed to the downstream side of the valve 4 so as to prevent the atmospheric components containing moisture and so on from entering the exhaust duct 10 or the roughing vacuum pump 9 while the apparatus is stopped.

During organic film formation, the inside of the chamber is set to a gas pressure from the transition flow region to the molecular flow region where the mean free path of molecules becomes several centimeters or more. As clear from Fig. 3, it is the gas pressure of 1 mTorr or more. During this film formation, the valve 1 is opened while the valve 3 is closed, thereby carrying out the gas exhaust by the use of the turbo-molecular pump 7 and the roughing vacuum pump 9. While an organic film is not formed and a substrate is carried in or out, the pressure inside the chamber 6 is set to the viscous flow region of 1 Torr or more. By setting the pressure to preferably 5 Torr or more and more preferably 10 Torr or more, the partial pressure of contaminants is relatively reduced and the mean free path thereof is shortened. In this event, the valve 1 is closed, the valve 3 is opened, and the valve 5 at a gas introducing portion is opened. Given that the gas flow rates are $f_1$ (cc/min) (gas introducing portion flow rate) and $f_2$ (cc/min) (turbo-molecular pump purge port flow rate), the pumping speeds of the pumps are $S_1$ (litter/sec) (turbo-molecular pump) and $S_2$ (litter/min) (roughing vacuum pump), and the pressure inside the chamber is Pc (Torr), relational equations thereof are

$$f_1 + f_2 = 79\ Pc\ S_2/60 \qquad (3)$$

during non-film formation, and

$$f_1 = 79\ Pc\ S_1 \qquad (4)$$

$$f_1 + f_2 = 79\ P_B\ S_2/60 \qquad (5)$$

during film formation, where $P_B$ represents a pressure on the downstream side of the turbo-molecular pump.

For example, given that $S_1$ = 12,000 litter/sec and $S_2$ = 2,400 litter/min in terms of film formation on a large glass substrate, metal substrate, or the like, even if it is set that $f_1$ = 2,000cc/min and $f_2$ = 1,600cc/min during non-film formation, the chamber pressure Pc during non-film formation only becomes approximately 1 Torr from the foregoing equation (3). If the valve 3 is throttled to set the effective pumping speed of the roughing vacuum pump 9 to 1/10, i.e. 240 litter/min, the chamber pressure Pc becomes approximately 10 Torr.

During film formation, the valve 3 is closed and the valve 1 is opened. Given that the gas flow rates at that time are $f_1$ = 1,000cc/min and $f_2$ = 1,600cc/min, the chamber pressure Pc is 1.05 mTorr from the foregoing equation (4) and $P_B$ on the downstream side of the turbo-molecular pump 7 is 0.82 Torr.

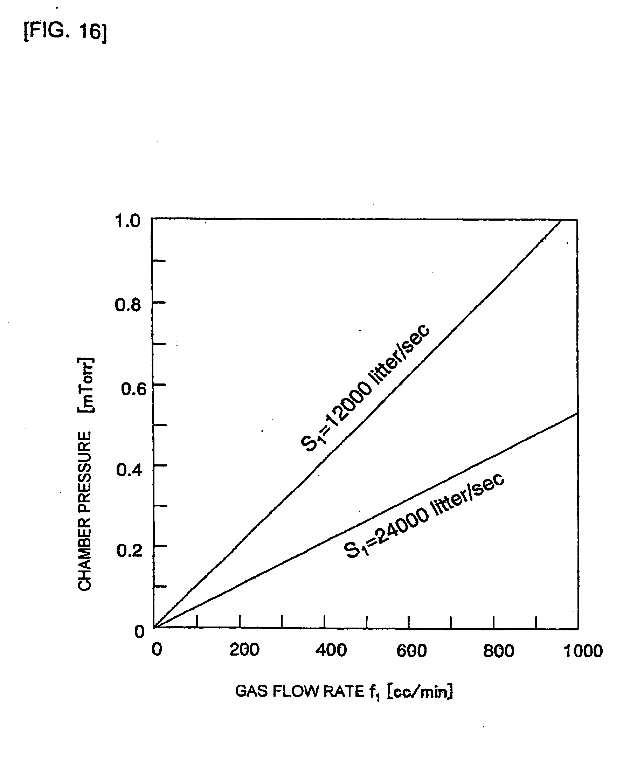

Fig. 16 shows the relationship between the gas flow rate fed to the chamber 6 in Fig. 15 and the chamber pressure. Naturally, if the pumping speed of the turbo-molecular pump 7 is set to double, i.e. 24,000 litter/sec, the chamber pressure Pc becomes half so as to be 0.52 mTorr in the transition flow region when $f_1$ = 1,000cc/min. If the valve is throttled to $f_1$ = 200cc/min, the chamber pressure Pc becomes 0.1 mTorr so that the mean free path of gas molecules increases to approximately several tens of centimeters.

The method of suppressing the organic compound contamination has been described above. Next, the organic film-forming technique will be described in detail.

Since an organic EL material is raised in temperature so as to be evaporated and formed a film on an opposing glass substrate, metal substrate, or the like, it is quite important not to decompose/dissociate organic EL molecules when the temperature is raised. There are two causes for decomposition/dissociation of the organic EL molecules. One is the decomposition/dissociation due to a catalytic effect exhibited by the surface in contact with the organic EL molecules when the temperature rises to a certain level. The other is the decomposition/dissociation due to oxidative decomposition caused by moisture ($H_2O$) or oxygen ($O_2$) adsorbed/occluded to/in the organic EL material. Therefore, before supplying the organic EL material into an evaporation film-forming container, it is necessary to place the organic EL material on a porous carbon heater and raise the temperature from 150°C to approximately 220°C to 230°C by causing a high purity $N_2$ gas (the content of $H_2O$ and $O_2$ is 100ppb or less and preferably 10ppb or less) to flow through porous carbon, thereby removing the adsorbed/occluded moisture and oxygen.

Next, description will be given of what has been clarified about a material with the least catalytic effect which is optimal for evaporating and gasifying the organic EL material.

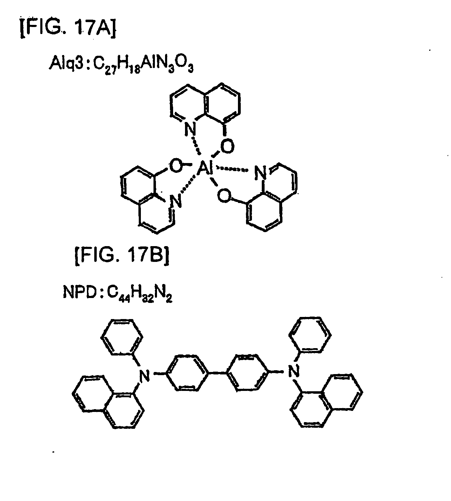

Description will be given of the results ofAlq3 ($C_{27}H_{18}AlN_3O_3$) and NPD ($C_{44}H_{32}N_2$) as typical organic EL materials. The molecular weights, melting points, and glass transition temperatures of Alq3 and NPD are 459.43 and 588.74, none due to sublimation properties and 280°C, and 175°C and 96°C, respectively. Figs. 17A and 17B show molecular structures of Alq3 and NPD. Molecules of Alq3 and NPD are evaporated to be gas molecules when raised to 270°C to 300°C or more.

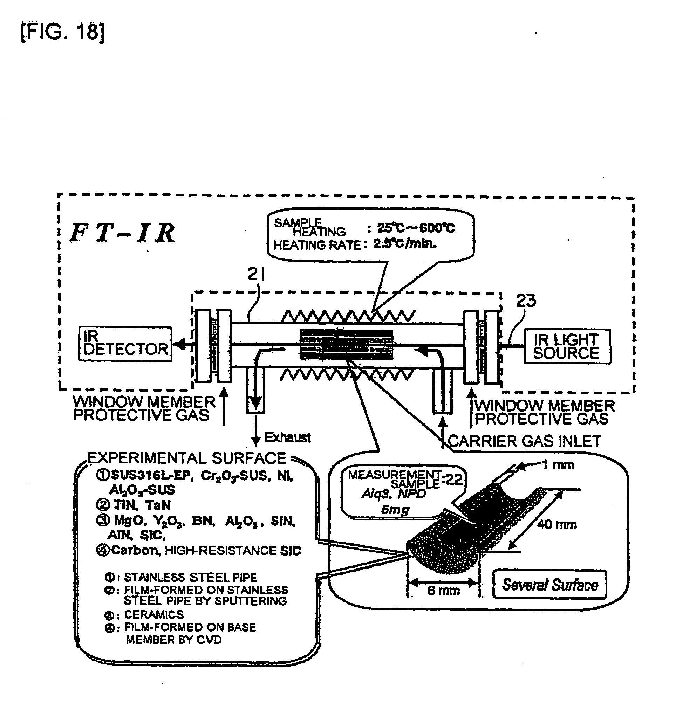

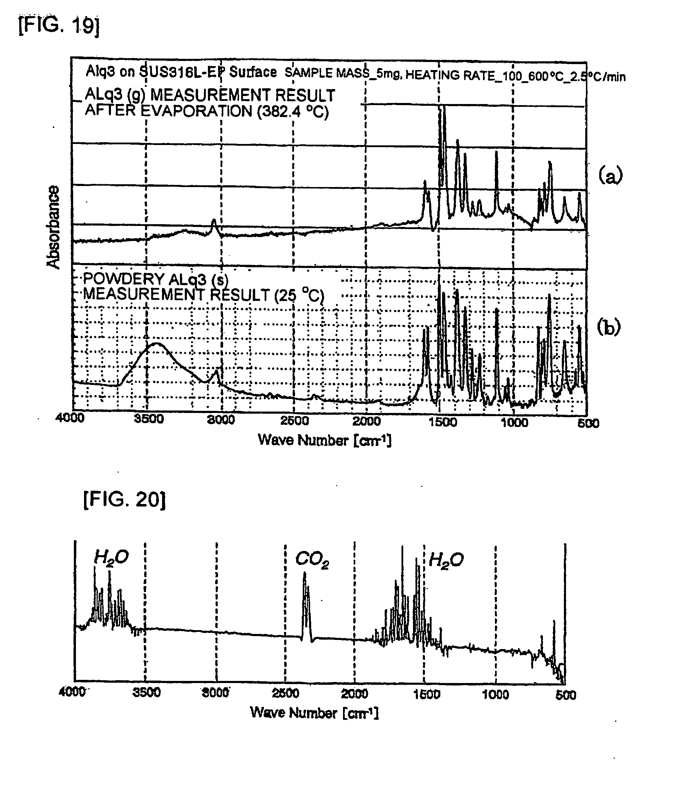

Evaporation dishes having the surfaces of various measurement samples 22 are inserted into a tube furnace 21 shown in Fig. 18 and the temperature of the tube furnace is raised while feeding a $N_2$ gas, thereby detecting infrared absorption spectra of the evaporated measurement sample 22, for example, Alq3 molecules, by the use of an FT-IR. The tube furnace 21 is a 1/2-inch stainless pipe. The $N_2$ gas is fed at 5cc/min in order to prevent deposition of Alq3 molecules on a window member and the $N_2$ gas is fed to the tube furnace 21 at 10cc/min. The speed of the $N_2$ gas flowing in the tube furnace 21 is 2.8mm/sec at room temperature (25°C) and 7.2mm/sec at 500°C. The temperature of the tube furnace 21 is raised from 25°C to 600°C by 2.5°C/min. Fig. 19, (a) and (b) show FT-IR absorption spectra when the temperature of the tube furnace 21 is raised to 382.4°C and FT-IR absorption spectra of solid Alq3 when Alq3 powder is formed into a thin layer. Although the peaks are observed only in solid Alq3 near 3400cm$^{-1}$ and near 2400cm$^{-1}$, the other peaks basically coincide with each other in both. Gasified Alq3 is not decomposed/dissociated.

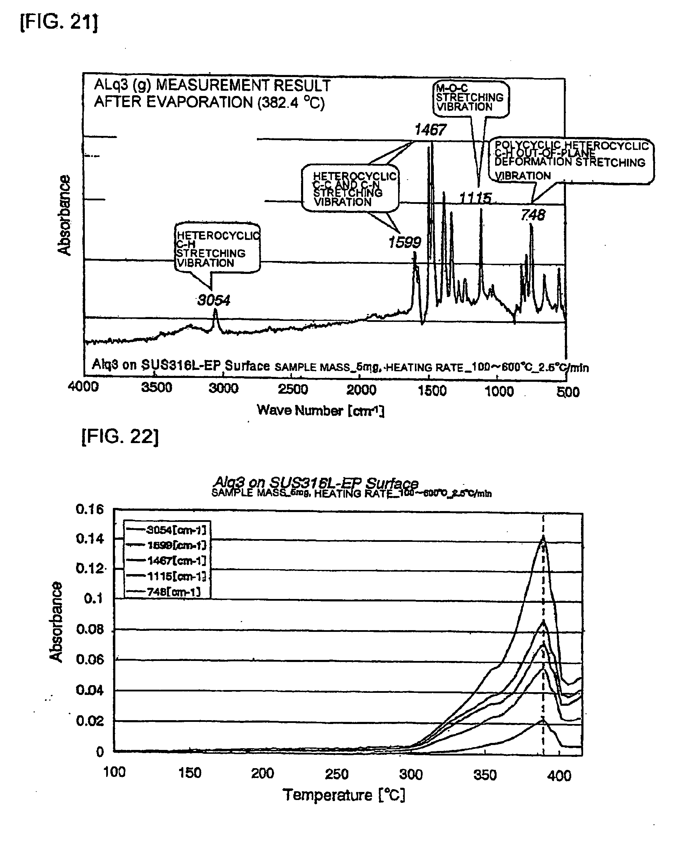

Fig. 20 shows FT-IR absorption spectra of moisture ($H_{20}$) and a $CO_2$ gas. There is a high possibility that the spectra near wave numbers of 3400cm$^{-1}$ and 2400cm$^{-1}$ in (b) of Fig. 19 are caused by moisture or $CO_2$ adsorbed on solid Alq3. Fig. 21 shows identification of the FT-IR absorption spectra of Alq3 gasified at 382.4°C. Fig. 22 shows the temperature dependence of intensities of respective absorption spectra (3054cm$^{-1}$, 1599cm$^{-1}$, 748cm$^{-1}$, 1115cm$^{-1}$, and 1467cm$^{-1}$) of Alq3 molecules in order from lower. When the temperature exceeds 300°C, Alq3 molecules evaporated into the gas phase gradually increase, but, at a temperature of 390.1°C, all the absorption spectra rapidly decrease. This is because the Alq3 molecules start to be decomposed/dissociated due to the catalytic effect of the electrolytically polished surface of stainless (SUS316L) used for the evaporation dish. Since the temperature of the evaporation dish should be raised for providing a large amount of Alq3 in the gas phase, the decomposition/dissociation temperature is desirably as high as possible.

Table 2 shows temperatures of decomposition/dissociation of Alq3 molecules with different surface materials of the evaporation dishes for evaporating Alq3. Resistance values of various materials in Table 2 are values measured by pushing resistance measurement terminals against various surfaces at a distance of 1cm therefrom.

[Table 2]

Table 2 Decomposition/Dissociation Temperatures of Alq3 Molecules according to Evaporation Dish Surface Materials

| Alq3 | Temperature [°C] | Resistance |
|---|---|---|
| Carbon | 422.5 | 2Ω/cm |
| SiC | 412.7 | 400Ω/cm |
| TaN | 409.5 | 0.8Ω/cm |
| AlN | 409.4 | 4000MΩ/cm or more |
| BN | 408.2 | 4000MΩ/cm or more |
| TiN | 405.1 | 0.2Ωcm |
| MgO | 404.9 | 4000MΩ/m or more |
| $Si_3N_4$ | 403.0 | 4000MΩ/cm or more |
| $Al_2O_3$-SUS | 402.0 | 0.3Ω/cm |
| High-Resistance SiC | 401.8 | 10MΩ/cm |
| Ni | 400.7 | 0.2Ω/cm |
| $Al_2O_3$ | 399.7 | 4000MΩ/cm or more |
| SiC (20%$H_2$/$N_2$) | 399.4 | 400kΩ/cm |
| $Y_2O_3$ | 397.0 | 4000MΩ/cm or more |
| SUS316L-EP | 390.1 | 0.2Ω/cm |
| $Cr_2O_3$-SUS | 389.3 | 0.2Ω/cm |

Carbon does not allow Alq3 molecules to be decomposed/dissociated up to 422.5°C, i.e. the highest temperature. Low-resistance SiC, TaN, AlN, BN, TiN, and MgO follow it. The material having as high a decomposition/dissociation start temperature as possible should be used for the evaporation dish and so on.

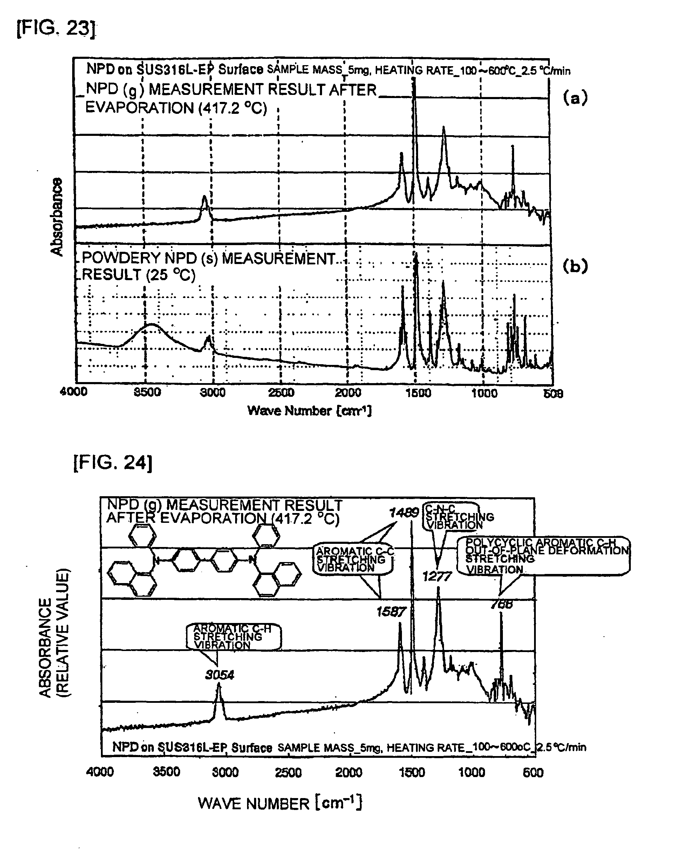

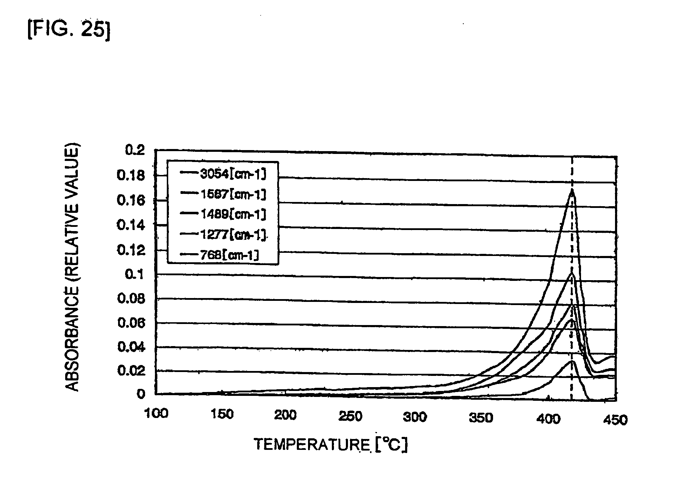

Next, description will be given with respect to NPD. At first, Fig. 23, (a) shows infrared absorption spectra of NPD molecules ($C_{44}H_{32}N_2$) evaporated at 417.2°C by the use of an evaporation dish with an electrolytically polished SUS316L surface and Fig. 23, (b) shows infrared absorption spectra of solid NPD. Both infrared absorption behaviors well coincide with each other except behaviors near a wave number of 3500cm$^{-1}$. Fig. 24 shows details of respective typical absorption spectra of NPD molecules evaporated into gas molecules. The difference in molecular structure from Alq3 appears as differences in respective absorption spectra. Fig. 25 shows the evaporation dish temperature dependence of absorbances at absorption peaks at respective wave numbers of 3054cm$^{-1}$, 1587cm$^{-1}$, 768cm$^{-1}$, 1277cm$^{-1}$, and 1489cm$^{-1}$ of the absorption spectra in order from lower. When the temperature exceeds 417.2°C, all the absorption peaks rapidly decrease. This is because the NPD molecules start to be decomposed/dissociated due to the catalytic effect of the electrolytically polished SUS316 surface.

Table 3 shows temperatures at which NPD molecules start decomposition/dissociation, with respect to various materials. Like in the case of Alq3 molecules, the decomposition/dissociation start temperature by carbon is the highest, which is 452.8°C. High-resistance SiC, low-resistance SiC, AlN, MgO, $Si_3N_4$, and $Al_2O_3$ follow it.

[Table 3]

Table 3 Decomposition/Dissociation Start Temperatures of NPD Molecules on Various Surfaces

| NPD | Temperature [°C] | Resistance |
|---|---|---|
| Carbon | 452.8 | 2Ω/cm |
| High-Resistance SiC | 431.5 | 10MΩ/cm |
| SiC | 426.2 | 400Ω/cm |
| AlN | 423.0 | 4000MΩ/cm or more |
| MgO | 420.1 | 4000MΩ/cm or more |
| $Si_3N_4$ | 418.8 | 4000MΩ/cm or more |
| $Al_2O_3$ | 417.9 | 4000MΩ/cm or more |
| SUS316L-EP | 417.2 | 0.2Ω/cm |
| $Al_2O_3$-SUS | 415.5 | 0.3Ω/cm |
| Ni | 414.4 | 0.2Ω/cm |
| TaN-SUS | 414.1 | 0.8Ω/cm |
| SiC (20%$H_2$/$N_2$) | 410.9 | 400kΩ/cm |
| $Y_2O_3$ | 408.3 | 4000MΩ/cm or more |
| $Cr_2O_3$-SUS | 407.2 | 0.2Ω/cm |
| BN | 403.7 | 4000MΩ/cm or more |
| TiN-SUS | 398.3 | 0.2Ω/cm |

Embodiment 1

Hereinbelow, Embodiment 1 of this invention will be described with reference to the drawings.

The materials each adapted to evaporate the organic EL material into the gas phase without decomposition/dissociation have been made clear. Description will be next given of an apparatus adapted to form a film of an expensive organic EL material on a glass substrate, plastic substrate, or metal substrate quite efficiently and at a high rate without decomposing/dissociating organic EL molecules.

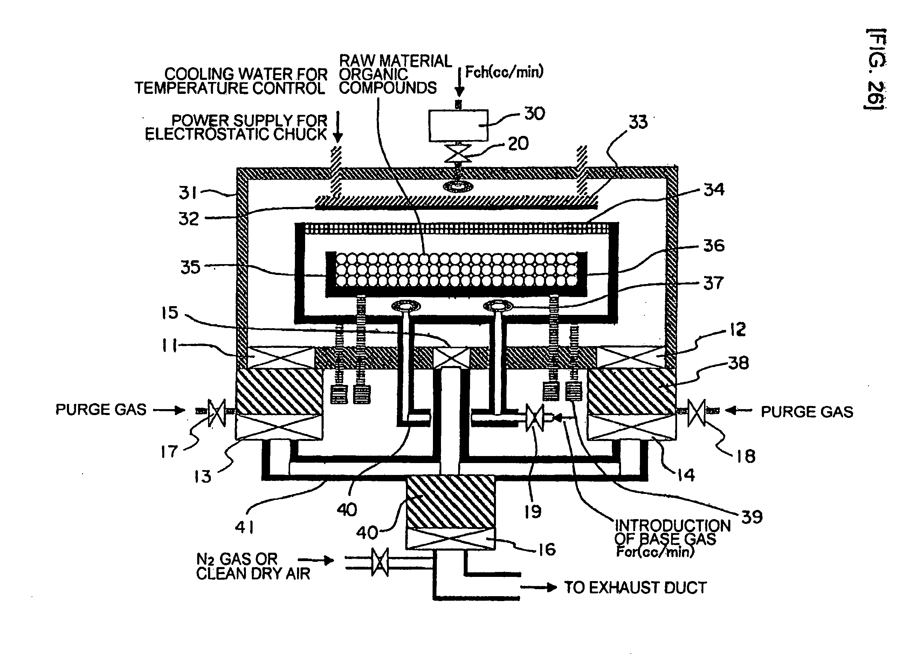

Referring to Fig. 26, description will be given of the mechanism for evaporating an organic EL material with respect to a substrate 32 located in a process chamber (container to be depressurized) 31, thereby carrying out film formation on the substrate 32.

In Fig. 26, there are included valves 11 to 20, the process chamber 31, the substrate 32, a stage 33, a gas ejection plate 34, an organic compound molecule ejection apparatus 35, an evaporation dish 36, ringshaped gas ejection portions 37, turbo-molecular pumps 38, a temperature control heater power supply 39, and a gas temperature control roughing vacuum pump 41.

Herein, it has been clarified as described before that various organic EL materials are each evaporated in a monomolecular state into the gas phase when heated to approximately 300°C or more. Further, it has also been clarified that the material which most reluctantly decomposes/dissociates the organic EL molecules is carbon.

Although there are various types where the surface of the substrate 32 such as the glass substrate or the metal substrate faces downward, upward, and sideward, description will be first given of the structure where the substrate is located with the surface thereof facing downward. Fig. 26 shows a sectional view of an organic film-forming apparatus in which the substrate 32 is located so as to face downward.

The substrate 32 such as the glass substrate, the plastic substrate, or the metal substrate is held in tight contact with the stage 33 by substrate fixing means such as an electrostatic chuck so that the entire surface of the substrate is controlled uniformly and strictly at a temperature near room temperature. The surface temperature of the stage 33 is uniformly and strictly controlled by circulating, over the entire surface of the stage, hydrogen-added cooling water removed of $N_2$ and $O_2$ dissolved from the atmosphere and added with hydrogen ($H_2$) at saturation solubility or less, for example, in an amount of 0.5 to 1.4ppm. The hydrogen-added water removed of $N_2$ and $O_2$ and added with $H_2$ has an oxidation-reduction potential (ORP) of -400mV and thus is water shifting to the reduction side by indeed as much as 1V as compared with +600mV, normally an ORP of water dissolved with $N_2$ and $O_2$ from the atmosphere, thereby not rusting metal or not breeding bacteria. Even if it is used for a long time in a hermetically sealed manner, the water quality is hardly degraded.

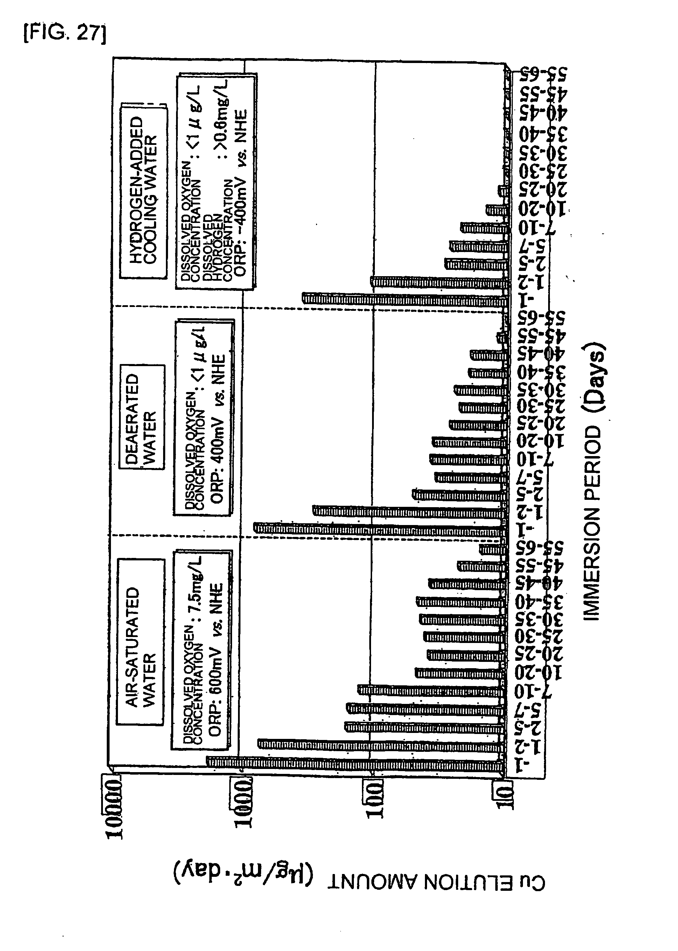

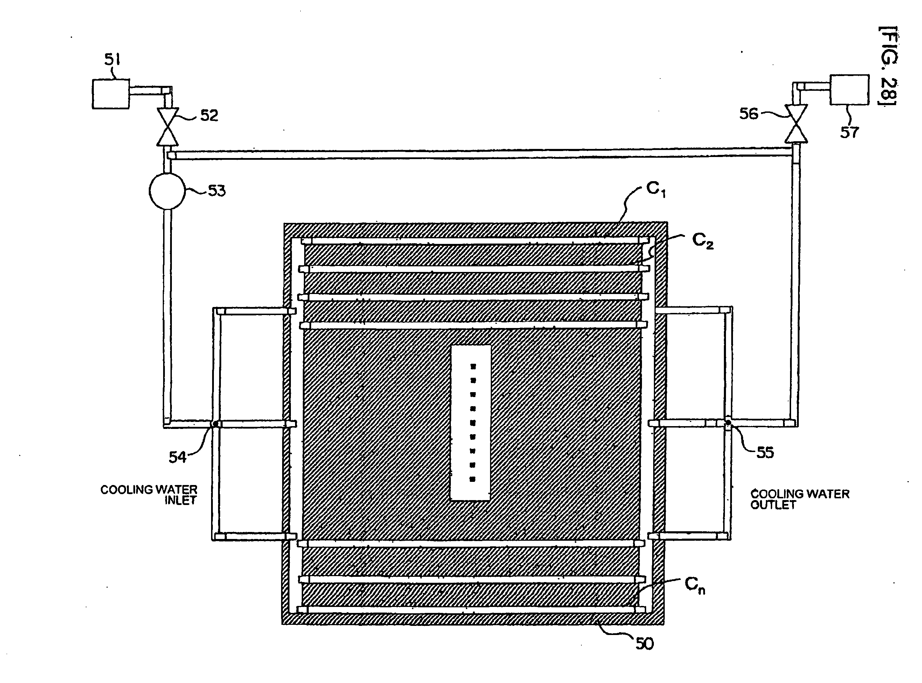

Fig. 27 shows the dissolution amount of metal into the hydrogen-added cooling water and, as comparison, shows the dissolution amounts of metal in air-saturated water and deaerated water being general cooling water. Cu is evaluated as the metal. It can be understood that the hydrogen-added cooling water has the effect of not corroding metal. Inside the substrate stage, a temperature control cooling water circulation system is constructed of copper or aluminum having high heat conductivity (high heat exchange efficiency) as shown in Fig. 28. In Fig. 28, there are included a substrate stage 50, flow rate controllers 51 and 57, valves 52 and 56, a compressor 53, and temperature sensors 54 and 55.

In order to control the temperature of the substrate surface at To (°C) near room temperature, the system is configured by keeping constant the cooling water amount flowing in the substrate stage 50, defining beforehand a correlation with a temperature $T_1$ (°C) at a cooling water outlet by the temperature sensor 55 to be "$T_0 > T_1$", discharging a portion of outlet-side cooling water raised in temperature into a return cooling water pipe, and introducing the same amount of cooling water from a cooling water supply pipe on the left side, thereby circulating the cooling water to the substrate stage 50 by the use of a circulation motor.

The number (layout pitch) of temperature control cooling water pipes $C_1$, $C_2$, to Cn of the substrate stage 50 and the inner diameter thereof are determined in the following manner. That is, the number (layout pitch) is determined so that the difference in temperature of the substrate surface is within ±1°C and preferably within ±0.3°C. This temperature variation on the substrate surface is directly reflected on thickness variation of an organic film formed. For example, when the substrate temperature is 30°C, the temperature difference of ±0.3°C corresponds to a temperature variation of 1%. The inner diameter of the cooling water pipe is set to a narrow inner diameter in a region where the cooling water forms slightly turbulent flow and not laminar flow so that the cooling water flowing inside the pipe efficiently carries out heat exchange with respect to the wall surface of the pipe. If the inner diameter is too narrow so that the cooling water forms excessively strong turbulent flow, although the heat exchange efficiency increases, the pressure drop for forcing the cooling water to flow becomes too large. Therefore, the load of a cooling water circulation pump becomes too large and hence the power consumption of the entire system becomes excessive. As a result, the Reynolds number of the cooling water flowing in the cooling water pipe is desirably set in the range of 1000 to 7000. In order to reduce the pressure drop and shorten a time in which the cooling water flows through the stage, the cooling water pipes $C_1$, $C_2$, to Cn are arranged in parallel. Unless the same amount of the cooling water flows in all the cooling water pipes, the temperature of the substrate surface is not maintained uniform.

The inner diameter of the cooling water pipe should be controlled quite accurately. The inner diameter should be controlled with an accuracy within ±1%. The size of a large-area substrate subjected to organic film formation is 1m, 2m, ..., or 5m or more. Therefore, the substrate stage becomes quite large. It is not easy to accurately control the inner diameter of a long narrow pipe. Even in that case, the cooling water amount flowing in all the cooling water pipes should be the same. Assuming that the flow rate is constant, a pressure drop Pd of cooling water in a region of slightly turbulent flow depends on an inner diameter D and a length L of a cooling water pipe as follows.

$$Pd \propto L/D^{\alpha}$$

In a turbulent flow region,

$$Pd \propto L/D^{\beta}$$

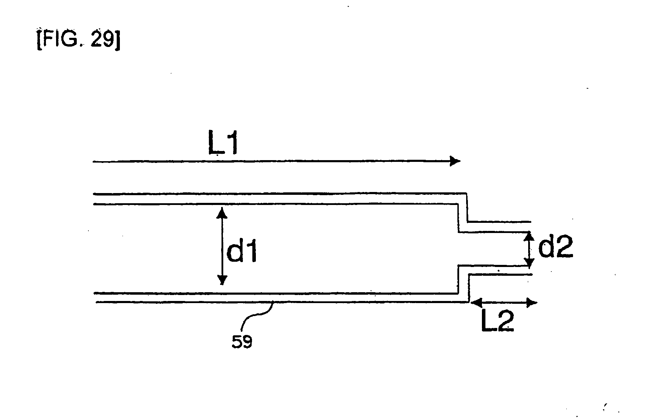

Therefore, inner diameter variations are respectively raised to the $\alpha$ powers and the ß powers, thereby leading to changes in pressure drop so as to be directly reflected on changes in flow rate. Herein, $\alpha = 2$ and ß = approximately 1.25. In order to solve this problem, at an inlet portion or an outlet portion of each cooling water pipe 59, a narrow pipe portion having an inner diameter d2 smaller than an inner diameter d1 of the cooling water pipe having a length L1 may be provided by a very short length L2 as shown in Fig. 29.

The inner diameter of this narrow pipe portion with the short length L2 is finished to an accuracy within ±0.3%.

A total pressure drop Pt of this pipe is the sum of a pressure drop Pt1 at the cooling water pipe portion and a pressure drop Pt2 at the narrow pipe portion.

$$Pt \propto L1/D1^a + L2/D2^b$$

By setting the narrow pipe portion pressure drop $L2/D2^6$ to be greater than the cooling water pipe portion pressure drop $L1/D1^a$, pressure drop variation is determined only by the narrow pipe portion inner diameter accuracy, so that in all the cooling water pipes the cooling water amount for each pipe can be the same. The inner diameter of a narrow pipe having a very short length can be controlled, for example, at approximately $\pm 0.1\%$.

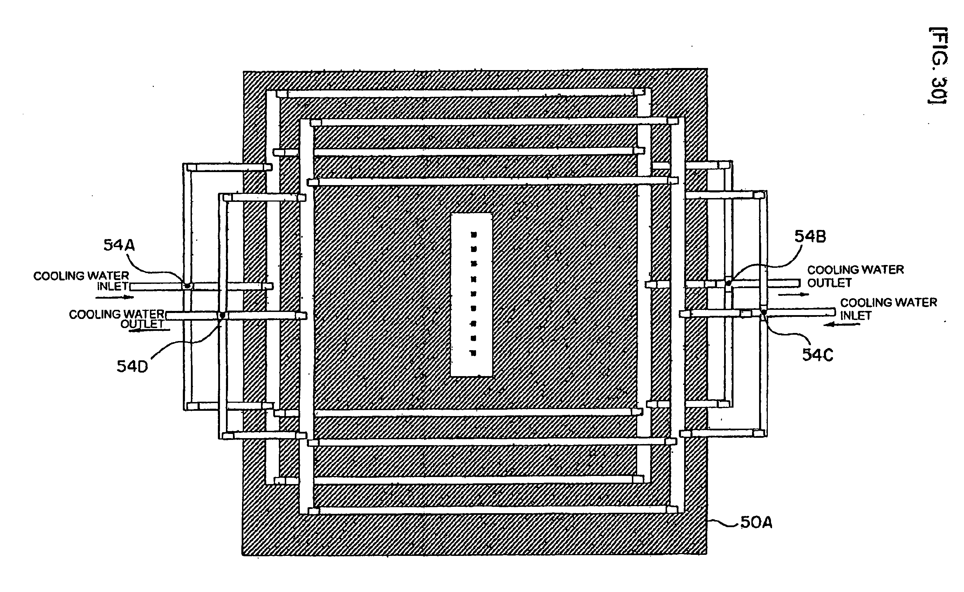

Fig. 30 shows the case where a substrate increases in size so that a substrate stage 50A increases in size to 2m or 5m. In this case, the substrate stage passing time of cooling water flowing in cooling water pipes increases so that there occurs a difference between left and right temperatures of the substrate stage 50 shown in Fig. 28. In such a case, like cooling water pipes shown in Fig. 30, by alternating cooling water flowing directions one by one so that the cooling water flows in opposite directions, i.e. right and left directions, uniformity in temperature of the entire surface of the substrate is improved. The technique of equalizing the temperature of the substrate surface has been described in detail. Variation in organic film thickness due to variation in substrate surface temperature is completely suppressed by this.

Next, an organic film-forming method will be described. In Fig. 26, the organic compound molecule ejection apparatus 35 is comprised of carbon that does not decompose/dissociate organic compound molecules up to the highest temperature as described before, SiC, or the like. An organic EL material or organic compound serving as a raw material is removed of adsorbed/occluded moisture and oxygen in a high purity $N_2$ atmosphere at a temperature of approximately 100°C to 220°C and then is located in the evaporation dish 36 located in the organic compound molecule ejection apparatus 35. The evaporation dish 36 is provided with a heater so as to be raised in temperature, thereby evaporating organic EL or organic compound molecules. The temperature of the wall surfaces of the organic compound molecule ejection apparatus 35 and the ejection plate surrounding the evaporation dish 36 is set higher than the temperature of the evaporation dish 36 in order to prevent adsorption of organic compound molecules evaporated from the evaporation dish 36. Normally, it is set higher by 20°C to 30°C. For example, it is like when the raw material is Alq3 and the constituent material of the wall surfaces and the ejection plate is carbon, since the decomposition/dissociation temperature of the raw material is 422°C, the temperature of the evaporation dish 36 is set to 370°C to 390°C and the temperature of the outer peripheral portions (the wall surfaces and the ejection plate) is set to 400°C to 410°C.

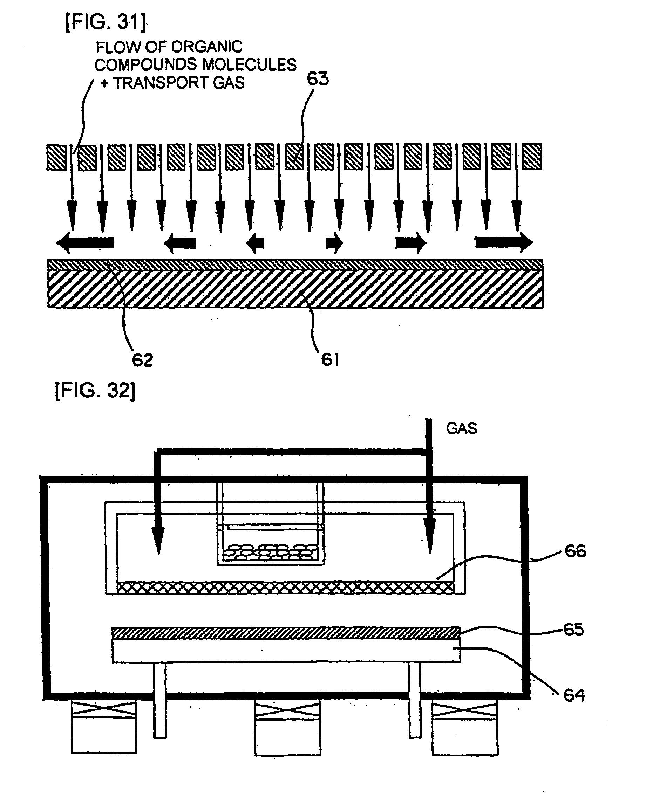

The evaporated organic compound molecules are confined inside the organic compound molecule ejection apparatus 35 (Fig. 26). As shown in Fig. 31, an organic compound molecule ejection plate 63 facing a substrate 61 is comprised of a porous material or has a shower plate structure. Naturally, the material has a high decomposition/dissociation temperature for organic compound molecules. The evaporation dish 36 (Fig. 26) has a small heat capacity so that, for example, its temperature can be changed between 270°C to 300°C (the state where organic compound molecules are not evaporated) and 370°C to 390°C (the state where organic compound molecules are evaporated) in a short time. The temperature of the outer peripheral portions is held constant. During non-film formation, the temperature of the evaporation dish 36 shown in Fig. 26 is set to a non-evaporation state, wherein the valves 11 and 12 are closed while the valve 15 is opened and the pressure inside the chamber 31 is held in a viscous flow region of 1 to 10 Torr by a gas flow rate Fch (cc/min) of Ar, $N_2$, or the like flowing in from the upper portion of the chamber 31. During film formation, the evaporation dish temperature is set to an organic compound evaporation state (high temperature), wherein the valve 15 is closed, the valves 11 and 12 are opened, and the valve 20 is closed to make Fch zero, while the valve 19 is opened to supply an inert gas at approximately 100cc/min to 1,000cc/min into the organic compound molecule ejection apparatus 35, thereby ejecting a gas toward the substrate 32 through the ejection plate (porous plate or shower plate) 34.

The ejected gas contains evaporated organic compound molecules so that the organic compound molecules are adsorbed on the substrate surface controlled at a temperature near room temperature. When the substrate has a large area, a gas having a mass greater than Ar with mass number 40 is desirable for accurately forming a gas flow pattern. Kr with mass number 80, Xe with mass number 131, or particularly krypton Kr is preferable. Naturally, it may also be a mixed gas of Ar and Kr or Ar and Xe. The organic compound molecule ejection gas is heated to the same temperature as that of the evaporation dish 36 by a heater before flowing into the organic compound molecule ejection apparatus 35. This is for preventing occurrence of change in temperature of the evaporation dish 36. The pressure inside the chamber 31 during organic film formation is set to a transition flow region of approximately several mTorr to 0.1 mTorr or less. This is the range where the mean free path of gas molecules is several mm to several tens of centimeters.

At the stage where an organic film having a predetermined thickness is formed on the substrate surface, the organic compound molecule ejection gas is stopped and the temperature of the evaporation dish is dropped to the temperature of the non-film formation state. When the film formation is finished, the valves 11 and 12 are closed, the valve 15 is opened, and the valve 20 is opened to introduce the gas such as Ar or $N_2$, thereby setting the pressure inside the chamber to approximately 1 to 10 Torr. In order to achieve the pressure balance between the inside of the organic compound molecule ejection apparatus and the inside of the chamber, it is effective to feed a small amount of gas inside the organic compound molecule ejection apparatus.

In a general substrate transfer system, a substrate is transferred while its surface to be formed with an element thereon faces upward. A complicated system is required for rotating downward, as shown in Fig. 26, a large-area substrate that is evenly and horizontally transferred with the surface thereof facing upward. If the surface of a substrate faces upward or a substrate is stood upright, its system is relatively simple.

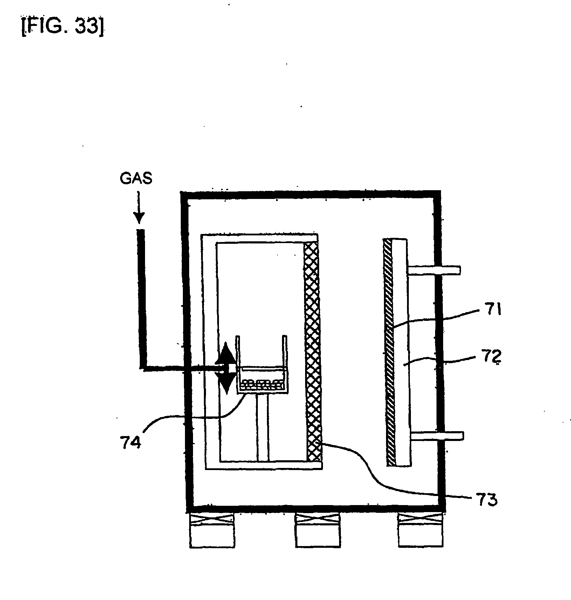

Fig. 32 shows the structure where a substrate 65 is located on a stage 64 so as to face upward and is opposed to an ejection plate 66. Further, Fig. 33 shows a sectional view of a film-forming apparatus adapted to carry out organic film formation with a structure in which a substrate 71 stood substantially vertically is located on a stage 72 and faces an ejection plate 73 and an evaporation dish 74 is disposed on the back side of the ejection plate 73. In either case, except that the direction of the substrate surface differs, the same structure, operation, and effect can be achieved as those of the apparatus of Fig. 26 with the substrate facing downward and, therefore, detailed explanation thereof is omitted.

As described before, even in the case of a single-color organic EL layer, it is necessary to form a plurality of film layers. In order to successively form the plurality of film layers, a plurality of organic compound ejection apparatuses as shown in Fig. 26 are juxtaposed so as to be aligned laterally inside the same chamber (container to be depressurized) and a substrate is configured to be movable over them (under them in the case of Fig. 32 and on the side of them in the case of Fig. 33) in parallel thereto in an alignment direction. Then, the substrate is stopped over (or under or on the side of) the first organic compound ejection apparatus and a first organic compound gas is ejected from the first organic compound ejection apparatus, thereby forming a film of a first organic compound layer on the substrate, and then, the substrate is automatically transferred and stopped over (or under or on the side of) the second organic compound ejection apparatus located adjacent to the first organic compound ejection apparatus and a second organic compound gas is ejected from the second organic compound ejection apparatus, thereby forming a film of a second organic compound layer on the first organic compound layer on the substrate. By carrying out in the same manner thereafter, the plurality of organic compound layers can be successively formed in the same chamber.

Embodiment 2

When organic compound molecules having a certain weight, i.e. a molecular weight of several hundreds to approximately 1000, are contained in a heavy base gas such as Xe or Kr and irradiated onto a substrate, the gas flow accurately reaches the substrate surface, which is thus more preferable. The organic compound molecules, which are solidified near room temperature, are adsorbed on the substrate surface and only the Xe gas or Kr gas is discharged to the outside by the exhaust pumps. Xe and Kr are highly expensive gases as compared with Ar and $N_2$ that are normally used industrially. It is desirable that a Xe or Kr recovery circulation system be provided subsequently to the roughing vacuum pump.

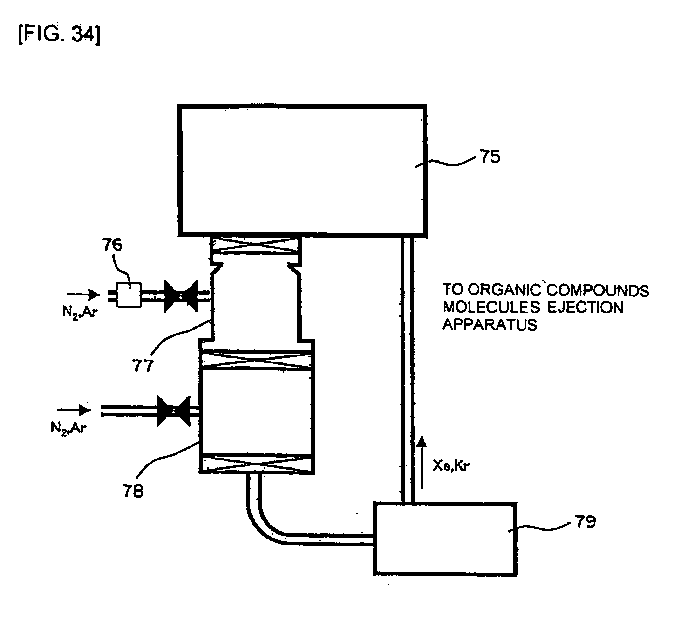

Fig. 34 shows a system for recovering/circulating an Xe gas or a Kr gas. In Fig. 34, a turbo-molecular pump 77 coupled to a chamber 75 through a valve is coupled to a roughing vacuum pump 78 and the turbo-molecular pump 77 and the roughing vacuum pump 78 receive Ar or $N_2$ and exhaust it to a recovery apparatus 79, thereby recovering the Xe gas or Kr gas.

In order to achieve the Xe gas or Kr gas recovery efficiency of 99.99% or more or 99.9% or more, the flow rate of the purge gas to the turbo-molecular pump 77 and the roughing vacuum pump 78 should be set equal to or less than that of the Xe gas or the Kr gas. Naturally, it should be necessary to prevent incorporation of evaporated components from grease used for bearings and so on of the pumps.

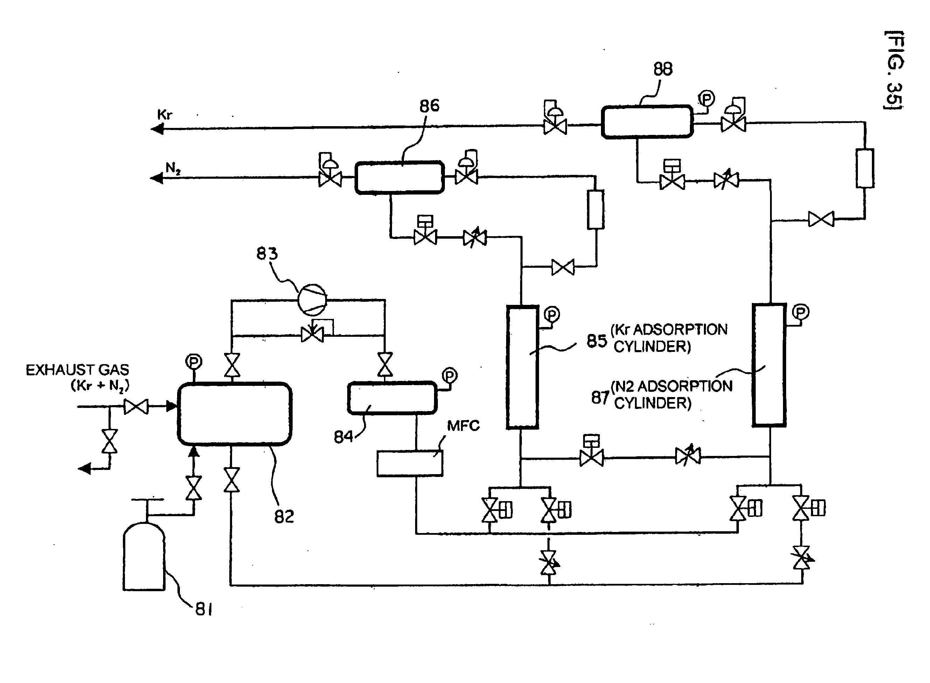

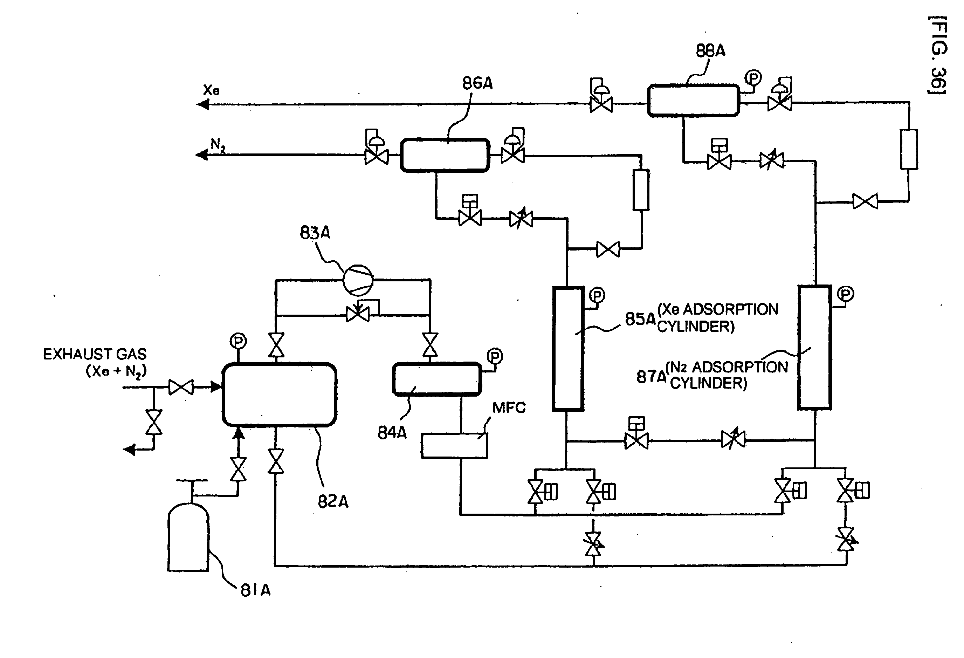

Figs. 35 and 36 are diagrams showing the structures of Kr and Xe circulation supply apparatuses, respectively. In Fig. 35, there are included a supplementary Kr bomb 81, a low-pressure raw material tank 82, a diaphragm compressor 83, a high-pressure raw material tank 84, a GL1 (Kr adsorption cylinder) 85, a GL1 product tank 86, a GL2 ($N_2$ adsorption cylinder) 87, and a GL2 product tank 88. Similarly, in Fig. 36, there are included a supplementary Xe bomb 81A, a low-pressure raw material tank 82A, a diaphragm compressor 83A, a high-pressure raw material tank 84A, a GL1 (Xe adsorption cylinder) 85A, a GL1 product tank 86A, a GL2 ($N_2$ adsorption cylinder) 87A, and a GL2 product tank 88A.

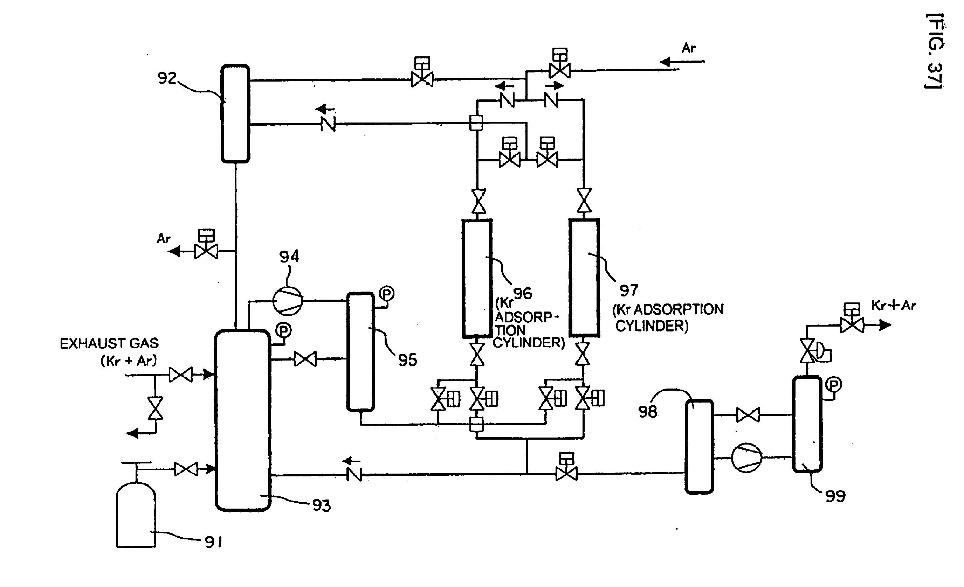

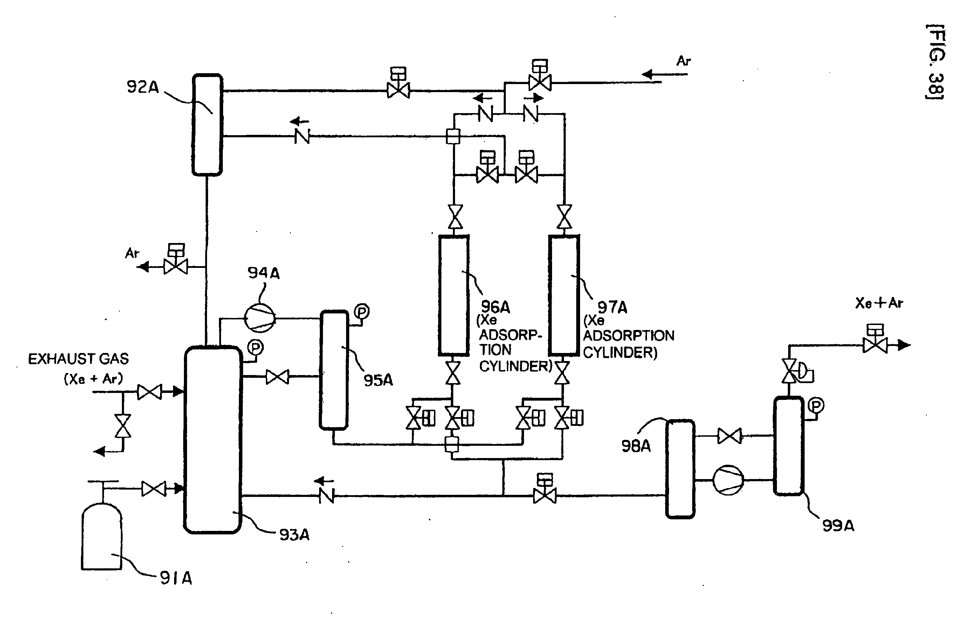

Further, Figs. 37 and 38 are diagrams showing the structures of circulation supply apparatuses for mixed gases of Ar and Kr, and Ar and Xe, respectively. In Fig. 37, there are included a supplementary Kr bomb 91, an Ar buffer tank 92, a low-pressure raw material tank 93, a diaphragm compressor 94, a high-pressure raw material tank 95, a GL1-1 (Kr adsorption cylinder) 96, a GL1-2 (Kr adsorption cylinder) 97, a "Kr + Ar" buffer tank 98, and a "Kr + Ar" product tank 99. Similarly, in Fig. 38, there are included a supplementary Xe bomb 91A, an Ar buffer tank 92A, a low-pressure raw material tank 93A, a diaphragm compressor 94A, a high-pressure raw material tank 95A, a GL1-1 (Xe adsorption cylinder) 96A, a GL1-2 (Xe adsorption cylinder) 97A, a "Xe + Ar" buffer tank 98A, and a "Xe + Ar" product tank 99A.

In each of them, the adsorption cylinder is provided therein with an adsorbent for adsorbing impurities such as noble gas components or nitrogen and Xe or Kr is separated/purified by changing the pressure inside the adsorption cylinder to repeat adsorption/desorption.

Embodiment 3

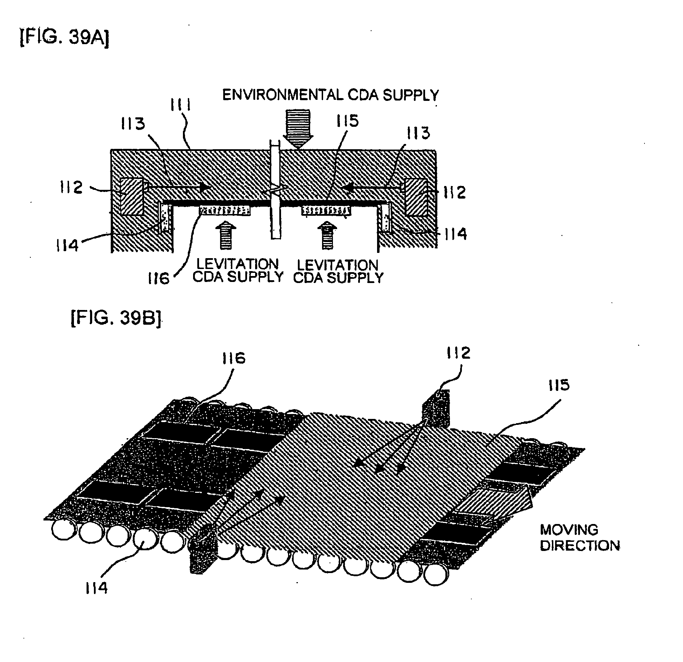

The lifetime and luminous properties of an organic EL element can be improved by removing organic compound contamination of an organic EL thin film. On the other hand, when transferring a glass substrate to a film-forming apparatus after cleaning, if use is comprised of a transfer apparatus that does not cause organic contamination on the substrate surface, the lifetime and luminous properties can be further improved. For such transfer of the glass substrate, it is most desirable to transfer the substrate, facing upward or downward, by gas levitation transfer with a clean dry air using porous ceramics as shown in Fig. 39 as an example. As shown in Embodiment 1 as the examples, when the substrate surface (the surface to be deposited with a film-forming material) faces upward in the film-forming apparatus, it is preferable that the substrate surface face upward during gas levitation transfer, when the substrate surface faces downward in the film-forming apparatus, it is preferable that the substrate surface face downward during gas levitation transfer, and when the substrate is stood substantially upright in the film-forming apparatus, it is preferable that the substrate surface face upward or downward during gas levitation transfer.

Figs. 39A and 39B show an example where a substrate is transferred to a film-forming apparatus by the use of a gas levitation transfer system using a clean dry air. In Figs. 39A and 39B, there are included a casing 111, soft X-ray ionizers 112, soft X-rays 113, driving rollers 114, a glass substrate 115, and levitation ceramics 116.

Since the substrate is levitated/transferred in a clean dry air atmosphere containing no moisture or no organic compound, not only ultrahigh-quality film formation is enabled because moisture or organic compound are not adsorbed at all on the outermost surface of the substrate, but also static electricity is not carried at all in gas levitation transfer using porous ceramics and, therefore, a problem such as dielectric breakdown or disconnection in an element or at element peripheral portions can be reduced, thereby enabling an improvement in production yield and a reduction in production cost.

Embodiment 4

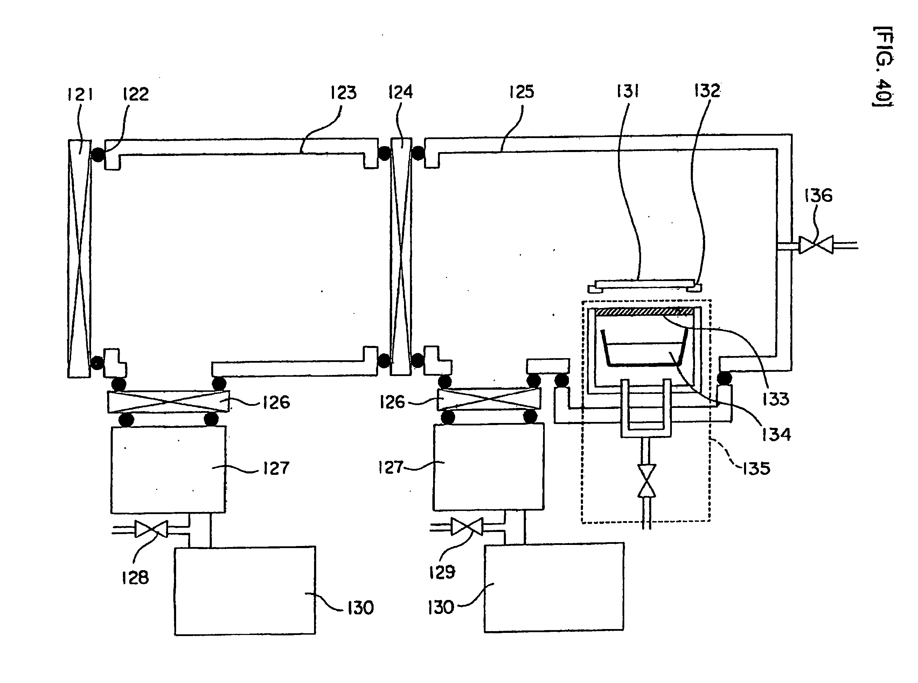

A film-forming apparatus in Embodiment 4 of this invention will be described with reference to Fig. 40. Fig. 40 is a sectional view showing one example of a deposition apparatus of this Embodiment 4, wherein the apparatus mainly comprises a container forming a process chamber 125 adapted to carry out a film-forming process, a substrate introduction chamber 123 coupled to the process chamber 125 through a gate valve 124 serving as a partition for the depressurizing chamber and maintaining airtightness of the process chamber 125, so as to carry in and out a substrate 131, a substrate introduction door 121 coupled to the substrate introduction chamber 123, a substrate holder 132 adapted to hold the substrate 131 in the container, primary pumps 127 coupled to the depressurizing chamber and the substrate introduction chamber 123 through pump gate valves 126, respectively, secondary pumps 130 coupled to exhaust sides of the primary pumps 127, pump purge gas introduction mechanisms 128 and 129 each located between the primary pump 127 and the secondary pump 130 for suppressing back diffusion of impurities from the secondary pump 130, and film-forming material supply means 135 coupled to the container for supplying a film-forming material 134 or a film-forming material precursor, and further comprises substrate placing means provided in the depressurizing chamber for placing the substrate 131 to be deposited with the film-forming material, film-forming material ejection means located so as to face the substrate 131 for ejecting the film-forming material 134 or the film-forming material precursor, supplied from the film-forming material supply means 135, toward the substrate surface, and gaskets 122 provided at connecting portions of the respective members for maintaining airtightness to the exterior.

Among them, in the film-forming apparatus in this embodiment, the gaskets 122 provided between the substrate introduction door 121 and the substrate introduction chamber 123 and between a deposition source chamber and a shutter mechanism are comprised of perfluoroelastomer and the other gaskets are comprised of Cu. By this configuration, it is possible to minimize the number of gaskets containing the organic compound and, further, even the gaskets containing the organic compound use the material whose organic compound release is very little, and therefore, it is possible to suppress incorporation of impurities, released from the gaskets, into an organic compound thin film formed on the substrate. Further, the deposition source container is comprised of $Al_2O_3$ and its inner surfaces are made substantially flat by polishing, and therefore, there is almost no catalysis so that it is possible to suppress thermal decomposition of the deposition material inside the deposition source container.

As a result of forming an organic EL layer by the use of this deposition apparatus and measuring the properties of an organic EL element, the brightness at the same current was improved by 30% as compared with the case of using conventional ones (general fluororubber gaskets and a general deposition source container) and the luminance half-decay lifetime became twice, i.e. 10000 hours. Since the organic compound release from the gaskets is suppressed and the decomposition of the deposition material in the deposition source container is suppressed, the incorporation of the impurities into the organic EL layer is suppressed. Therefore, it was possible to improve the brightness and the lifetime.

Industrial Applicability

According to this invention, since an evaporated film-forming material reaches the surface of a substrate by the flow of a transport gas, the film-forming conditions can be controlled by the flow of the gas and hence a uniform thin film can be deposited on the large-area substrate. The film-forming apparatus of this invention thoroughly eliminates generation of the organic compound contamination substance/material decomposition dissociation substance that adversely affects the properties of the film-forming material, and thus can deposit a high-quality thin film. By using the film-forming apparatus and the film-forming method of this invention for forming an organic EL element, it is possible to obtain a high-quality organic EL display device with high brightness and long lifetime. The film-forming apparatus and the film-forming method of this invention are effectively applicable not only to the organic EL field but also to all the other fields where raw materials are evaporated to form films with respect to flat panel display devices, semiconductor devices, and other general electronic devices.

**Claims**

1. A film-forming apparatus **characterized by** comprising a container (31) to be depressurized, a depressurizing mechanism (38, 41) directly or indirectly coupled to said container (31), a film-forming material supply apparatus (34-37) located inside or outside said container (31) and directly or indirectly coupled to said container (31) for supplying a film-forming material or a film-forming material precursor, and a substrate-placing portion (33) located in said container (31) for placing a substrate (32) on which the film-forming material is deposited, wherein said film-forming material supply apparatus (34-37) has at least an evaporation mechanism (35, 36) for evaporating said film-forming material or said film-forming material precursor and a portion of said evaporation mechanism (35, 36), to which said film-forming material or said film-forming material precursor is to be contacted, is composed of a material having a low gas discharge or a material having a low catalytic effect;
wherein said material having a low gas discharge is defined as generating gas at a film-forming material evaporation temperature in an amount equal to or less than an amount of gas generated by SUS-316L material having the same shape and having an electrolytically polished surface at the same temperature or as generating gas in said film-forming apparatus in an amount corresponding to a partial pressure of not more than 1/10 of a film-forming pressure;
wherein said material having a low catalytic effect is defined as exhibiting, when brought into contact with said film-forming material or said film-forming material precursor and raised in temperature, a material decomposition temperature for said film-forming material or said film-forming material precursor equal to or higher than SUS-316L material having the same shape and having an electrolytically polished surface or as exhibiting a temperature difference of 20°C or less between a decomposition start temperature exhibited by said film-forming material or said film-forming material precursor alone and a decomposition start temperature exhibited by said film-forming material or said film-forming material precursor when brought into contact with said material; and
wherein said evaporation mechanism (35, 36) comprises a heating mechanism for heating said film-forming material or said film-forming material precursor to a first temperature equal to or higher than an evaporation temperature at which said film-forming material or said film-forming material precursor is evaporated, and a heating means for heating a predetermined portion inside said container (31) to a second temperature exceeding said first temperature, said predetermined portion being a portion adapted to contact the evaporated film-forming material or film-forming material precursor and excluding said substrate (32) and said substrate holding portion (33).

2. A film-forming apparatus according to claim 1, **characterized by** comprising a transport gas-supplying mechanism (34, 37) for supplying a gas that transports the evaporated film-forming material or film-forming material precursor to a surface of said substrate (32).

3. A film-forming apparatus according to claim 1, **characterized in that** a temperature of said substrate (32) is maintained at a third temperature lower than said evaporation temperature.

4. A film-forming apparatus according to claim 1, **characterized in that** said first temperature and said second temperature are lower than a temperature at which the evaporated film-forming material or film-forming material precursor is decomposed.

5. A film-forming apparatus according to claim 1, **characterized in that** said second temperature is higher than said first temperature by 20°C or more.

6. A film-forming apparatus according to claim 3, **characterized in that** said third temperature is equal to or lower than said evaporation temperature.

7. A film-forming apparatus according to claim 6, **characterized in that** said film-forming material is a material for organic EL and said third temperature is less than 100°C.

8. A film-forming apparatus according to claim 2, **characterized in that** said transport gas-supplying mechanism (34, 37) comprises a portion (37) adapted to introduce said transport gas from the outside into a container holding said film-forming material or said film-forming material precursor and a gas ejection portion (34) having a plurality of small holes and located so as to face said substrate (32), and said gas transports said evaporated film-forming material or film-forming material precursor to the surface of said substrate (32) through said gas ejection portion (34).

9. A film-forming apparatus according to claim 2, **characterized in that** said transport gas-supplying mechanism (34, 37) comprises a mechanism (37) for supplying said transport gas from the outside so as to contact said evaporated film-forming material or film-forming material precursor and a mechanism (34) for ejecting the transport gas containing said evaporated film-forming material or film-forming material precursor toward said substrate.

10. A film-forming apparatus according to claim 9, **characterized in that** said mechanism (34) for ejecting comprises a shower plate or a plate comprised of a porous material.

11. A film-forming apparatus according to claim 1, **characterized in that** said evaporation mechanism (35, 36) is configured to evaporate said film-forming material or said film-forming material precursor during execution of film formation and to stop evaporation during non-execution of film formation.

12. A film-forming apparatus according to claim 1, **characterized in that** said depressurizing mechanism (38, 41) maintains the inside of said container (31) at a pressure of 10 mTorr to 0.1 mTorr during execution of film formation.

13. A film-forming apparatus according to claim 12, **characterized in that** said depressurizing means (38, 41) causes a gas flow in said container (31) to be in a molecular flow region during the execution of film formation and causes a gas flow in said container to be in an intermediate flow region or a viscous flow region at least for a certain period during non-execution of film formation.

14. A film-forming apparatus according to claim 9, **characterized in that** said gas is a xenon (Xe) gas.

15. A film-forming apparatus according to claim 2, **characterized in that** said gas contains an inert gas as a main component.

16. A film-forming apparatus according to claim 2, **characterized in that** said gas contains at least one of nitrogen (N), Xe, Kr, Ar, Ne, and He.

17. A film-forming apparatus according to claim 1, **characterized in that** said depressurizing mechanism (38, 41) comprises a turbo-molecular pump (38) and a roughing vacuum pump (41) and a portion for supplying an inert gas is provided between said turbo-molecular pump (38) and said roughing vacuum pump (41).

18. A film-forming apparatus according to claim 1, **characterized in that** a pressure in said container (31) during film formation and that during non-film formation are in a molecular flow pressure region and an intermediate flow pressure region or a viscous flow pressure region, respectively.

19. A film-forming method for depositing a film of a predetermined material on a substrate using the film-forming apparatus according to claim 1, said film-forming method **characterized by** comprising a step of evaporating a raw material used for forming said film of the predetermined material and a step of transporting the evaporated raw material to a surface of said substrate (32) by the use of a gas.

20. A film-forming method according to claim 19, **characterized in that** said evaporating step comprises a step of heating said raw material to a first temperature equal to or higher than a temperature at which said raw material is evaporated, and a step of heating a predetermined portion inside said container (31) to a second temperature exceeding said temperature at which said raw material is evaporated.

21. A film-forming method according to claim 20, **characterized in that** a temperature of said substrate (32) is maintained at a third temperature lower than said temperature at which said raw material is evaporated.

22. A film-forming method according to claim 20, **characterized in that** said first temperature and said second temperature are lower than a temperature at which the evaporated raw material is decomposed.

23. A film-forming method according to claim 22, **characterized in that** said second temperature is higher than said first temperature.

24. A film-forming method according to claim 22, **characterized in that** said second temperature is higher than said first temperature by 20°C or more.

25. A film-forming method according to claim 21, **characterized in that** said third temperature is equal to or lower than said temperature at which said raw material is evaporated.

26. A film-forming method according to claim 21, **characterized in that** said predetermined material is an organic EL material and said third temperature is less than 100°C.

27. A film-forming method according to claim 19, **characterized in that** said raw material is said predetermined material or a precursor of said predetermined material.

28. A film-forming method according to claim 19, **characterized by** placing said raw material in a heat-resistant container, placing said heat-resistant container in a gas container, introducing said gas into said gas container to transport said evaporated raw material by the use of said gas, and causing said gas to reach the surface of said substrate through a gas ejection portion (34) while transporting said evaporated raw material, wherein said gas ejection portion (34) having a plurality of small holes is provided so as to face said substrate (32).

29. A film-forming method according to claim 19, **characterized by** maintaining the inside of said container (31) at a pressure of 10 mTorr to 0.1 mTorr during execution of film formation and maintaining the inside of said container (31) at a reduced pressure of 1 Torr or more at least for a certain period during non-execution of film formation.

30. A film-forming method according to claim 19, **characterized by** causing a gas flow in said container (31) to be in a molecular flow region during execution of film formation and causing a gas flow in said container (31) to be in an intermediate flow region or a viscous flow region at least for a certain period during non-execution of film formation.

31. A film-forming method according to claim 19, **characterized in that** said gas is a xenon (Xe) gas.

32. A film-forming method according to claim 19, **characterized in that** said gas contains an inert gas as a main component.

33. A film-forming method according to claim 32, **characterized in that** said inert gas contains at least one of nitrogen (N), Xe, Kr, Ar, Ne, and He.

34. A film-forming method according to claim 19, **characterized in that** said predetermined material is an organic EL element material.

35. An organic EL device manufacturing method **characterized by** comprising a step of forming a film of an organic EL element material by the use of the film-forming method according to claim 19.

36. An electronic device manufacturing method **characterized by** comprising a step of forming a film layer of a predetermined material by the use of the film-forming method according to claim 19.

**Patentansprüche**

1. Filmbildende Vorrichtung, die **gekennzeichnet ist durch** Umfassen eines Behälters (31), der im Druck herabzusetzen ist, einer druckherabsetzenden Vorrichtung (38, 41), die direkt oder indirekt mit dem Behälter (31) verbunden ist, einer filmbildendes-Material-Zufuhrvorrichtung (34-37), die sich innerhalb oder außerhalb des Behälters (31) befindet und direkt oder indirekt mit dem Behälter (31) verbunden ist, um ein filmbildendes Material oder einen filmbildenden Materialvorläufer zuzuführen, und eines Substrat-Platzierungs-Bereichs (33), der im Behälter (31) angeordnet ist, um ein Substrat (32), auf dem das filmbildende Material abgeschieden wird, zu platzieren, wobei die filmbildendes-Material-Zufuhrvorrichtung (34-37) zumindest eine Verdampfungsvorrichtung (35, 36) aufweist um das filmbildende Material oder den filmbildenden Materialvorläufer zu verdampfen und ein Bereich der Verdampfungsvorrichtung (35, 36), mit dem das filmbildende Material oder der filmbildende Materialvorläufer in Kontakt zu bringen ist, **durch** ein Material mit einer niedrigen Gasentladung oder ein Material mit einem geringen katalytischen Effekt gebildet ist;

wobei das Material mit der niedrigen Gasentladung spezifiziert ist bei einer Verdampfungstemperatur des filmbildenden Materials in einem Maße Gas zu bilden, das gleich oder geringer ist als das Maß an Gas, das SUS-316L Material mit derselben Gestalt und einer elektrolytisch polierten Oberfläche bei derselben Temperatur bildet oder in der filmbildenden Vorrichtung in einem Maße Gas zu bilden, das einem Partialdruck von nicht mehr als 1/10 eines filmbildenden Drucks entspricht;

wobei das Material mit der geringen katalytischen Wirkung spezifiziert ist, wenn es mit dem filmbildenden Material oder dem filmbildenen Materialvorläufer in Kontakt gebracht ist und seine Temperatur erhöht ist, eine Materialzersetzungstemperatur für das filmbildende Material oder den filmbildenden Materialvorläufer aufzuweisen, die gleich wie oder höher als die von SU-316L Material mit der selben Gestalt und einer elektrolytische polierten Oberfläche ist, oder einen Temperaturunterschied von 20°C oder weniger aufzuweisen zwischen einer Zersetzungsstarttemperatur, die das filmbildende Material oder der filmbildende Materialvorläufer alleine aufweist, und einer Zersetzungsstarttemperatur, die das filmbildende Material oder der filmbildende Materialvorläufer aufweist, wenn es mit dem Material in Kontakt gebracht ist; und

wobei die Verdampfungsvorrichtung (35, 36) eine Heizvorrichtung umfasst zum Erhitzen des filmbildenden Materials oder des filmbildenden Materialvorläufers auf eine erste Temperatur gleich wie oder höher als eine Verdampfungstemperatur, bei der das filmbildende Material oder der filmbildende Materialvorläufer verdampft wird, und ein Heizmittel zum Erhitzen eines vorbestimmten Bereichs innerhalb des Behälters (31) auf eine zweite Temperatur, die die erste Temperatur übersteigt, wobei der vorbestimmte Bereich ein Bereich ist, der angepasst ist das filmbildende Material oder den filmbildenden Materialvorläufer zu berühren und das Substrat (32) und den Substrathaltebereich (33) ausschließt.

2. Filmbildende Vorrichtung gemäß Anspruch 1, die **gekennzeichnet ist durch** Umfassen einer Transportgas-Zufuhrvorrichtung (34, 37), um ein Gas, das das verdampfte filmbildende Material oder den filmbildenden Materialvorläufer zu einer Oberfläche des Substrats (32) transportiert, zuzuführen.

3. Filmbildende Vorrichtung gemäß Anspruch 1, **dadurch gekennzeichnet, dass** eine Temperatur des Substrats (32) auf einer dritten Temperatur gehalten wird, die niedriger als die Verdampfungstemperatur ist.

4. Filmbildende Vorrichtung gemäß Anspruch 1, **dadurch gekennzeichnet, dass** die erste Temperatur und die zweite Temperatur niedriger als eine Temperatur sind, bei der das filmbildende Material oder der filmbildende Materialvorläufer zersetzt wird.

5. Filmbildende Vorrichtung gemäß Anspruch 1, **dadurch gekennzeichnet, dass** die zweite Temperatur 20°C oder mehr über der ersten Temperatur liegt.

6. Filmbildende Vorrichtung gemäß Anspruch 3, **dadurch gekennzeichnet, dass** die dritte Temperatur gleich der oder niedriger als die Verdampfungstemperatur ist.

7. Filmbildende Vorrichtung gemäß Anspruch 6, **dadurch gekennzeichnet, dass** das filmbildende Material ein Material für organische EL ist und die dritte Temperatur unter 100°C liegt.

8. Filmbildende Vorrichtung gemäß Anspruch 2, **dadurch gekennzeichnet, dass** die Transportgas-Zufuhrvorrichtung (34, 37) einen Bereich (37) umfasst, der ausgebildet ist das Transportgas von außerhalb in einen Behälter, der das filmbildende Material oder den filmbildenden Materialvorläufer enthält, einzuleiten und einen Gasausstoßbereich (34), der eine Anzahl kleiner Löcher aufweist und derart angeordnet ist, dass er dem Substrat (32) zugewandt ist, und das Gas das filmbildende Material oder den filmbildenden Materialvorläufer zur Oberfläche des Substrats (32) durch den Gasausstoßbereich (34) transportiert.

9. Filmbildende Vorrichtung gemäß Anspruch 2, **dadurch gekennzeichnet, dass** die Transportgas-Zufuhrvorrichtung (34, 37) eine Vorrichtung (37) zur Zuführung des Transportgases von außerhalb umfasst, um das verdampfte filmbildende Material oder den filmbildenden Materialvorläufer aufzunehmen, und eine Vorrichtung (34), um das Transportgas, das das filmbildende Material oder den filmbildenden Materialvorläufer enthält, zum Substrat hin auszustoßen.

10. Filmbildende Vorrichtung gemäß Anspruch 9, **dadurch gekennzeichnet, dass** die Vorrichtung (34) zum Ausstoßen eine Strahlscheibe oder eine Scheibe aus porösem Material aufweist.

11. Filmbildende Vorrichtung gemäß Anspruch 1, **dadurch gekennzeichnet, dass** die Verdampfungsvorrichtung (35, 36) ausgebildet ist das filmbildende Material oder den filmbildenden Materialvorläufer während der Durchführung der Filmbildung zu verdampfen und das Verdampfen während der Nicht-Durchführung der Filmbildung zu stoppen.

12. Filmbildende Vorrichtung gemäß Anspruch 1, **dadurch gekennzeichnet, dass** die druckherabsetzende Vorrichtung (38, 41) das Innere des Behälters (31) bei einem Druck von 10 mTorr bis 0,1 mTorr während der Durchführung der Filmbildung hält.

13. Filmbildende Vorrichtung gemäß Anspruch 12, **dadurch gekennzeichnet, dass** die druckherabsetzende Vorrichtung (38, 41) einen Gasfluss im Behälter (31) veranlasst während der Durchführung der Filmbildung in einem Molekularströmungsbereich zu sein und einen Gasfluss im Behälter veranlasst, zumindest für einen gewissen Zeitraum während der Nicht-Durchführung der Filmbildung, in einem dazwischenliegenden Strömungsbereich oder einem viskosen Strömungsbereich zu sein.

14. Filmbildende Vorrichtung gemäß Anspruch 9, **dadurch gekennzeichnet, dass** das Gas ein Xenon(Xe)-Gas ist.

15. Filmbildende Vorrichtung gemäß Anspruch 2, **dadurch gekennzeichnet, dass** das Gas als einen Hauptbestandteil ein Inert enthält.

16. Filmbildende Vorrichtung gemäß Anspruch 2, **dadurch gekennzeichnet, dass** das Gas zumindest ein Element aus der Gruppe Stickstoff (N), Xe, Kr, Ar, Ne und He enthält.

17. Filmbildende Vorrichtung gemäß Anspruch 1, **dadurch gekennzeichnet, dass** die druckherabsetzende Vorrichtung (38, 41) eine Turbomolekular-Pumpe (38) und eine Vorvakuumpumpe (41) umfasst und ein Bereich zur Zuführung von Inertgas zwischen der Turbomolekularpumpe (38) und der Vorvakuumpumpe (41) vorgesehen ist.

18. Filmbildende Vorrichtung gemäß Anspruch 1, **dadurch gekennzeichnet, dass** ein Druck im Behälter (31) während der Filmbildung und derjenige während der Nicht-Filmbildung sich jeweils in einem Molekularströmungsdruckbereich und einem Zwischenströmungsdruckbereich oder einem Viskosströmungsdruckbereich befinden.

19. Filmbildendes Verfahren zum Abscheiden eines Films eines vorbestimmten Materials auf einem Substrat unter Verwendung der filmbildenden Vorrichtung gemäß Anspruch 1, wobei die filmbildende Methode **dadurch gekennzeichnet ist, dass** sie einen Schritt des Verdampfens eines Rohmaterials zum Bilden des Films des vorbestimmten Materials und einen Schritt des Transportierens des verdampften Rohmaterials zu einer Oberfläche des Substrats (32) unter Verwendung eines Gases umfasst.

20. Filmbildendes Verfahren gemäß Anspruch 19, **dadurch gekennzeichnet, dass** der Schritt des Verdampfens einen Schritt des Erhitzens des Rohmaterials auf eine erste Temperatur, die gleich wie oder höher als eine Temperatur ist, bei welcher das Rohmaterial verdampft wird, und einen Schritt des Erhitzens eines vorbestimmten Bereichs innerhalb des Behälters (31) auf eine zweite Temperatur, die die Temperatur, bei welcher das Rohmaterial verdampft wird, übersteigt, umfasst.

21. Filmbildendes Verfahren gemäß Anspruch 20, **dadurch gekennzeichnet, dass** eine Temperatur des Substrats (32) auf einer dritten Temperatur gehalten wird, die niedriger als die Temperatur, bei welcher das Rohmaterial verdampft wird, ist.

22. Filmbildendes Verfahren gemäß Anspruch 20, **dadurch gekennzeichnet, dass** die erste Temperatur und die zweite Temperatur niedriger als eine Temperatur, bei der das verdampft Rohmaterial zersetzt wird, sind.

**23.** Filmbildendes Verfahren gemäß Anspruch 22, **dadurch gekennzeichnet, dass** die zweite Temperatur über der ersten Temperatur liegt.

**24.** Filmbildendes Verfahren gemäß Anspruch 22, **dadurch gekennzeichnet, dass** die zweite Temperatur 20°C oder mehr über der ersten Temperatur liegt.

**25.** Filmbildendes Verfahren gemäß Anspruch 21, **dadurch gekennzeichnet, dass** die dritte Temperatur gleich der oder niedriger als die Temperatur, bei welcher das Rohmaterial verdampft wird, ist.

**26.** Filmbildendes Verfahren gemäß Anspruch 21, **dadurch gekennzeichnet, dass** das vorbestimmte Material ein organisches EL-Material ist und die dritte Temperatur unter 100°C liegt.

**27.** Filmbildendes Verfahren gemäß Anspruch 19, **dadurch gekennzeichnet, dass** das Rohmaterial ein vorbestimmtes Material ist oder ein Vorläufer des vorbestimmten Materials.

**28.** Filmbildendes Verfahren gemäß Anspruch 19, **gekennzeichnet durch** Platzieren des Rohmaterials in einem hitzebeständigen Behälter, Platzieren des hitzebeständigen Behälters in einem Gasbehälter, Einleiten des Gases in den Gasbehälter, um das verdampfte Rohmaterial unter Verwendung des Gases zu transportieren, und Bewirken, dass das Gas die Oberfläche des Substrats durch einen Gasausstoßbereich (34) erreicht während des Transportierens des verdampften Rohmaterials, wobei der Gasausstoßbereich (34), der eine Anzahl kleiner Löcher aufweist, so vorgesehen ist, dass er dem Substrat (32) zugewandt ist.

**29.** Filmbildendes Verfahren gemäß Anspruch 19, **gekennzeichnet durch** Halten des Inneren des Behälters (31) bei einem Druck von 10 mTorr bis 0,1 mTorr während der Durchführung der Filmbildung und Halten des Inneren des Behälters (31) bei einem verminderten Druck von 1 Torr oder mehr, zumindest für einen gewissen Zeitraum während der Nicht-Durchführung der Filmbildung.

**30.** Filmbildendes Verfahren gemäß Anspruch 19, **gekennzeichnet durch** Hervorrufen, dass ein Gasfluss im Behälter (31) in einem Molekularströmungsbereich ist während der Durchführung der Filmbildung und Hervorrufen, dass ein Gasfluss im Behälter (31) in einem dazwischenliegenden Strömungsbereich oder einem viskosen Strömungsbereich ist, zumindest für einen gewissen Zeitraum während der Nicht-Durchführung der Filmbildung.

**31.** Filmbildendes Verfahren gemäß Anspruch 19, **dadurch gekennzeichnet, dass** das Gas ein Xenon(Xe)-Gas ist.

**32.** Filmbildendes Verfahren gemäß Anspruch 19, **dadurch gekennzeichnet, dass** das Gas als Hauptbestandteil ein Inertgas enthält.

**33.** Filmbildendes Verfahren gemäß Anspruch 32, **dadurch gekennzeichnet, dass** das Inertgas zumindest ein Element aus der Gruppe Stickstoff (N), Xe, Kr, Ar, Ne und He enthält.

**34.** Filmbildendes Verfahren gemäß Anspruch 19, **dadurch gekennzeichnet, dass** das vorbestimmte Material ein organisches EL-Element-Material ist.

**35.** Herstellungsverfahren für eine organische EL-Vorrichtung, **gekennzeichnet durch** Umfassen eines Schrittes des Bildens eines Films eines organischen EL-Element-Materials unter Verwendung des filmbildenden Verfahrens gemäß Anspruch 19.

**36.** Herstellungsverfahren für eine elektronische Vorrichtung, **gekennzeichnet durch** Umfassen eines Schrittes des Bildens einer Filmschicht eines vorbestimmten Materials unter Verwendung des filmbildenden Verfahrens gemäß Anspruch 19.

**Revendications**

**1.** Appareil de formation de film **caractérisé en ce qu'**il comprend un récipient (31) devant être dépressurisé, un mécanisme de dépressurisation (38, 41) couplé directement ou indirectement audit récipient (31), un appareil de fourniture de matière de formation de film (34-37) situé à l'intérieur ou à l'extérieur dudit récipient (31) et couplé directement ou indirectement audit récipient (31) pour fournir une matière de formation de film ou un précurseur de matière de formation de film, et une partie de mise en place de substrat (33) située dans ledit récipient (31) pour la mise en place d'un substrat (32) sur lequel la matière de formation de film est déposée, dans lequel ledit appareil de fourniture de matière de formation de film (34-37) possède au moins un mécanisme d'évaporation (35, 36) pour assurer l'évaporation de ladite matière de formation de film ou dudit précurseur de matière de formation de film et une partie dudit mécanisme d'évaporation (35, 36), avec laquelle ladite matière de formation de film ou ledit précurseur de matière de formation de film doit être mis(e) en contact, est composée d'une matière ayant une faible décharge de gaz ou d'une matière ayant un faible effet catalytique ;

dans lequel ladite matière ayant une faible décharge de gaz est définie comme générant du gaz à une température d'évaporation de la matière de formation de film dans une quantité inférieure ou égale à une quantité de gaz générée par la matière SUS-316L ayant la même forme et ayant une surface polie électrolytiquement à la même température ou comme générant du gaz dans ledit appareil de formation de film dans une quantité correspondant à une pression partielle ne dépassant pas 1/10 d'une pression de formation de film ;

dans lequel ladite matière ayant un faible effet catalytique est définie comme présentant, lorsqu'elle est mise en contact avec ladite matière de formation de film ou ledit précurseur de matière de formation de film et que sa température est augmentée, une température de décomposition de matière pour ladite matière de formation de film ou ledit précurseur de matière de formation de film supérieure ou égale à celle de la matière SUS-316L ayant la même forme et ayant une surface polie électrolytiquement ou comme présentant une différence de température de 20°C ou moins entre une température de début de décomposition présentée par ladite matière de formation de film ou ledit précurseur de matière de formation de film seul et une température de début de décomposition présentée par ladite matière de formation de film ou ledit précurseur de matière de formation de film lors de sa mise en contact avec ladite matière ; et

dans lequel ledit mécanisme d'évaporation (35, 36) comprend un mécanisme de chauffage pour chauffer ladite matière de formation de film ou ledit précurseur de matière de formation de film à une première température supérieure ou égale à une température d'évaporation à laquelle ladite matière de formation de film ou ledit précurseur de matière de formation de film est évaporé(e), et des moyens de chauffage pour chauffer une partie prédéterminée à l'intérieur dudit récipient (31) à une deuxième température dépassant ladite première température, ladite partie prédéterminée étant une partie adaptée pour être en contact avec la matière de formation de film ou le précurseur de matière de formation de film évaporé(e) et excluant ledit substrat (32) et ladite partie de maintien de substrat (33).

2. Appareil de formation de film selon la revendication 1, **caractérisé en ce qu'**il comprend un mécanisme de fourniture de gaz de transport (34, 37) pour fournir un gaz qui transporte la matière de formation de film ou le précurseur de matière de formation de film vers une surface dudit substrat (32).

3. Appareil de formation de film selon la revendication 1, **caractérisé en ce qu'**une température dudit substrat (32) est maintenue à une troisième température inférieure à ladite température d'évaporation.

4. Appareil de formation de film selon la revendication 1, **caractérisé en ce que** ladite première température et ladite deuxième température sont inférieures à une température à laquelle la matière de formation de film ou le précurseur de matière de formation de film est décomposé.

5. Appareil de formation de film selon la revendication 1, **caractérisé en ce que** ladite deuxième température est supérieure à ladite première température de 20°C ou plus.

6. Appareil de formation de film selon la revendication 3, **caractérisé en ce que** ladite troisième température est inférieure ou égale à ladite température d'évaporation.

7. Appareil de formation de film selon la revendication 6, **caractérisé en ce que** ladite matière de formation de film est une matière pour EL organique et ladite troisième température est inférieure à 100°C.

8. Appareil de formation de film selon la revendication 2, **caractérisé en ce que** ledit mécanisme de fourniture de gaz de transport (34, 37) comprend une partie (37) adaptée pour introduire ledit gaz de transport depuis l'extérieur dans un récipient contenant ladite matière de formation de film ou ledit précurseur de matière de formation de film et une partie d'éjection de gaz (34) ayant une pluralité de petits trous et positionnée de sorte à faire face audit substrat (32), et ledit gaz transporte ladite matière de formation de film ou ledit précurseur de matière de formation de film évaporé(e) vers la surface dudit substrat (32) à travers ladite partie d'éjection de gaz (34).

9. Appareil de formation de film selon la revendication 2, **caractérisé en ce que** ledit mécanisme de fourniture de gaz de transport (34, 37) comprend un mécanisme (37) pour fournir ledit gaz de transport depuis l'extérieur de sorte qu'il entre en contact avec ladite matière de formation de film ou ledit précurseur de matière de formation de film et un mécanisme (34) pour éjecter le gaz de transport contenant ladite matière de formation de film ou ledit précurseur de matière de formation de film vers ledit substrat.

10. Appareil de formation de film selon la revendication 9, **caractérisé en ce que** ledit mécanisme d'éjection (34) comprend une plaque de douche ou une plaque composée d'une matière poreuse.

11. Appareil de formation de film selon la revendication 1, **caractérisé en ce que** ledit mécanisme d'évaporation (35, 36) est configuré pour assurer l'évaporation de ladite matière de formation de film ou dudit précurseur de matière de formation de film lors de l'exécution de la formation de film et pour arrêter l'évaporation lors de la non-exécution de la formation de film.

12. Appareil de formation de film selon la revendication 1, **caractérisé en ce que** ledit mécanisme de dépressurisation (38, 41) maintient l'intérieur dudit récipient (31) à une pression de 10 mTorr à 0,1 mTorr lors de l'exécution de la formation de film.

13. Appareil de formation de film selon la revendication 12, **caractérisé en ce que** lesdits moyens de dépressurisation (38, 41) agissent sur un écoulement de gaz dans ledit récipient (31) pour qu'il se trouve dans une région d'écoulement moléculaire lors de l'exécution de la formation de film et agissent sur un écoulement de gaz dans ledit récipient pour qu'il se trouve dans une région d'écoulement intermédiaire ou une région d'écoulement visqueuse au moins pendant une certaine période lors de la non-exécution de la formation de film.

14. Appareil de formation de film selon la revendication 9, **caractérisé en ce que** ledit gaz est un gaz xénon (Xe).

15. Appareil de formation de film selon la revendication 2, **caractérisé en ce que** ledit gaz contient un gaz inerte comme composant principal.

16. Appareil de formation de film selon la revendication 2, **caractérisé en ce que** ledit gaz contient au moins l'un parmi azote (N), Xe, Kr, Ar, Ne et He.

17. Appareil de formation de film selon la revendication 1, **caractérisé en ce que** ledit mécanisme de dépressurisation (38, 41). comprend une pompe turbomoléculaire (38) et une pompe de prévidage (41) et une partie pour fournir un gaz inerte est prévue entre ladite pompe turbomoléculaire (38) et ladite pompe de prévidage (41).

18. Appareil de formation de film selon la revendication 1, **caractérisé en ce qu'**une pression dans ledit récipient (31) lors de la formation de film et qu'une pression lors de la non-formation de film se trouvent dans une région de pression d'écoulement moléculaire et une région de pression d'écoulement intermédiaire ou une région de pression d'écoulement visqueuse, respectivement.

19. Procédé de formation de film pour déposer un film d'une matière prédéterminée sur un substrat en utilisant l'appareil de formation de film selon la revendication 1, ledit procédé de formation de film étant **caractérisé en ce qu'**il comprend une étape d'évaporation d'une matière première utilisée pour former ledit film de la matière prédéterminée et une étape de transport de ladite matière première évaporée vers une surface dudit substrat (32) grâce à l'utilisation d'un gaz.

20. Procédé de formation de film selon la revendication 19, **caractérisé en ce que** ladite étape d'évaporation comprend une étape de chauffage de ladite matière première à une première température supérieure ou égale à une température à laquelle ladite matière première est évaporée, et une étape de chauffage d'une partie prédéterminée à l'intérieur dudit récipient (31) à une deuxième température supérieure à ladite température à laquelle ladite matière première est évaporée.

21. Procédé de formation de film selon la revendication 20, **caractérisé en ce qu'**une température dudit substrat (32) est maintenue à une troisième température inférieure à ladite température à laquelle ladite matière première est évaporée.

22. Procédé de formation de film selon la revendication 20, **caractérisé en ce que** ladite première température et ladite deuxième température sont inférieures à une température à laquelle la matière première évaporée est décomposée.

**23.** Procédé de formation de film selon la revendication 22, **caractérisé en ce que** ladite deuxième température est supérieure à ladite première température.

**24.** Procédé de formation de film selon la revendication 22, **caractérisé en ce que** ladite deuxième température est supérieure à ladite première température de 20°C ou plus.

**25.** Procédé de formation de film selon la revendication 21, **caractérisé en ce que** ladite troisième température est inférieure ou égale à ladite température à laquelle ladite matière première est évaporée.

**26.** Procédé de formation de film selon la revendication 21, **caractérisé en ce que** ladite matière prédéterminée est une matière EL organique et ladite troisième température est inférieure à 100°C.

**27.** Procédé de formation de film selon la revendication 19, **caractérisé en ce que** ladite matière première est ladite matière prédéterminée ou un précurseur de ladite matière prédéterminée.

**28.** Procédé de formation de film selon la revendication 19, **caractérisé par** la mise en place de ladite matière première dans un récipient résistant à la chaleur, la mise en place dudit récipient résistant à la chaleur dans un récipient de gaz, l'introduction dudit gaz dans ledit récipient de gaz pour transporter ladite matière première évaporée grâce à l'utilisation dudit gaz, et l'action sur ledit gaz pour qu'il atteigne la surface dudit substrat à travers une partie d'éjection de gaz (34) tout en transportant ladite matière première évaporée, dans lequel ladite partie d'éjection de gaz (34) ayant une pluralité de petits trous est positionnée de sorte à faire face audit substrat (32).

**29.** Procédé de formation de film selon la revendication 19, **caractérisé par** le maintien de l'intérieur dudit récipient (31) à une pression de 10 mTorr à 0,1 mTorr lors de l'exécution de la formation de film et le maintien de l'intérieur dudit récipient (31) à une pression réduite de 1 Torr ou plus au moins pendant une certaine période lors de la non-exécution de la formation de film.

**30.** Procédé de formation de film selon la revendication 19, **caractérisé en ce qu'**il agit sur un écoulement de gaz dans ledit récipient (31) pour qu'il se trouve dans une région d'écoulement moléculaire lors de l'exécution de la formation de film et **en ce qu'**il agit sur un écoulement de gaz dans ledit récipient (31) pour qu'il se trouve dans une région d'écoulement intermédiaire ou une région d'écoulement visqueuse au moins pendant une certaine période lors de la non-exécution de la formation de film.

**31.** Procédé de formation de film selon la revendication 19, **caractérisé en ce que** ledit gaz est un gaz xénon (Xe).

**32.** Procédé de formation de film selon la revendication 19, **caractérisé en ce que** ledit gaz contient un gaz inerte comme composant principal.

**33.** Procédé de formation de film selon la revendication 32, **caractérisé en ce que** ledit gaz inerte contient au moins l'un parmi azote (N), Xe, Kr, Ar, Ne et He.

**34.** Procédé de formation de film selon la revendication 19, **caractérisé en ce que** ladite matière prédéterminée est une matière d'élément EL organique.

**35.** Procédé de fabrication de dispositif EL organique **caractérisé en ce qu'**il comprend une étape de formation d'une matière d'élément EL organique grâce à l'utilisation du procédé de formation de film selon la revendication 19.

**36.** Procédé de fabrication de dispositif électronique **caractérisé en ce qu'**il comprend une étape de formation d'une couche de film d'une matière prédéterminée grâce à l'utilisation du procédé de formation de film selon la revendication 19.

[FIG. 1]

~108
~107
~106
~105
~104
~103
~102
~101

[FIG. 2]

[FIG. 3]

[FIG. 4]

[FIG. 5]

(STORAGE TIME 60 MINUTES, ROOM TEMPERATURE)

[FIG. 6]

[FIG. 7]

[FIG. 8]

[FIG. 9]

[FIG.10]

[FIG. 11]

[FIG. 12A]

[FIG. 12B]

[FIG. 13]

[FIG. 14A]

STRAIGHT-CHAIN HYDROCARBON

[FIG. 14B]

PHTHALATE ESTER

[FIG. 14C]

CYCLIC SILOXANE

[FIG. 15]

[FIG. 16]

[FIG. 17A]

Alq3 : $C_{27}H_{18}AlN_3O_3$

[FIG. 17B]

NPD : $C_{44}H_{32}N_2$

[FIG. 18]

[FIG. 19]

Alq3 on SUS316L-EP Surface SAMPLE MASS_5mg, HEATING RATE_100_600°C_2.5°C/min

ALq3 (g) MEASUREMENT RESULT AFTER EVAPORATION (382.4 °C)

(a)

POWDERY ALq3 (s) MEASUREMENT RESULT (25 °C)

(b)

Absorbance

Wave Number [cm⁻¹]

[FIG. 20]

$H_2O$    $CO_2$    $H_2O$

Wave Number [cm⁻¹]

[FIG. 21]

ALq3 (g) MEASUREMENT RESULT AFTER EVAPORATION (382.4 °C)

M-O-C STRETCHING VIBRATION

1467

POLYCYCLIC HETEROCYCLIC C-H OUT-OF-PLANE DEFORMATION STRETCHING VIBRATION

HETEROCYCLIC C-C AND C-N STRETCHING VIBRATION

1115

748

HETEROCYCLIC C-H STRETCHING VIBRATION

1599

3054

Alq3 on SUS316L-EP Surface SAMPLE MASS_5mg, HEATING RATE_100~600°C_2.5°C/min

Absorbance

Wave Number [cm⁻¹]

[FIG. 22]

Alq3 on SUS316L-EP Surface
SAMPLE MASS_5mg, HEATING RATE_100~600°C_2.5°C/min

— 3054[cm-1]
— 1599[cm-1]
— 1467[cm-1]
— 1115[cm-1]
— 748[cm-1]

Absorbance

Temperature [°C]

[FIG. 23]

[FIG. 24]

[FIG. 25]

[FIG. 26]

[FIG. 27]

[FIG. 28]

COOLING WATER OUTLET

COOLING WATER INLET

[FIG. 29]

[FIG. 30]

EP 1 741 802 B1

54A

COOLING WATER
INLET

COOLING WATER
OUTLET

54D

54B

COOLING WATER
OUTLET

COOLING WATER
INLET

54C

50A

[FIG. 31]

FLOW OF ORGANIC
COMPOUNDS MOLECULES
+ TRANSPORT GAS

[FIG. 32]

GAS

[FIG. 33]

[FIG. 34]

75

76

N$_2$,Ar

77

N$_2$,Ar

78

TO ORGANIC COMPOUNDS
MOLECULES EJECTION
APPARATUS

Xe,Kr

79

[FIG. 35]

[FIG. 36]

88A

86A

Xe

N₂

83A

85A (Xe ADSORPTION CYLINDER)

87A (N₂ ADSORPTION CYLINDER)

EXHAUST GAS
(Xe + N₂)

84A

MFC

82A

81A

EP 1 741 802 B1

[FIG. 37]

[FIG. 38]

[FIG. 39A]

ENVIRONMENTAL CDA SUPPLY

113    111                    115           113

112                                              112

114                                              114

116    LEVITATION    LEVITATION
       CDA SUPPLY    CDA SUPPLY

[FIG. 39B]

116                                112

                                              115

                                         MOVING
                                         DIRECTION

114

[FIG. 40]

**EP 1 741 802 B1**

**REFERENCES CITED IN THE DESCRIPTION**

**Patent documents cited in the description**

- JP 2004079904 A
- JP 2005058978 A
- US 20060278162 A1
- JP 11189862 A